# EUROPEAN PATENT APPLICATION

(11) **EP 4 475 649 A2**
(43) Date of publication of application: **11.12.2024**
(21) Application number: 24176567.6
(22) Date of filing: 17.05.2024
(51) Int. Cl.: H10K 59/131

(54) **DISPLAY DEVICE**

(30) Priority: 08.06.2023 KR 20230073784
(71) Applicant: Samsung Display Co., Ltd., Yongin-si, Gyeonggi-do 17113 (KR)
(72) Inventor: Lim, Jaekeun, 17113 Giheung-gu, Yongin-si, Gyeonggi-do (KR); Roh, Jinyoung, 17113 Giheung-gu, Yongin-si, Gyeonggi-do (KR); Gu, Bon-Seog, 17113 Giheung-gu, Yongin-si, Gyeonggi-do (KR); Seo, Hae-Kwan, 17113 Giheung-gu, Yongin-si, Gyeonggi-do (KR)
(74) Representative: Dr. Weitzel & Partner

(57) **Abstract**

A display device includes: a first-first pixel circuit portion positioned in a first pixel row and a first pixel column, a first-second pixel circuit portion positioned in the first pixel row and a second pixel column, a second-first pixel circuit portion positioned in a second pixel row and the first pixel column, a second-second pixel circuit portion positioned in the second pixel row and the second pixel column, a first sub-data line overlapping in a plan view the first-first pixel circuit portion and the second-first pixel circuit portion and extending in a column direction, and a second sub-data line overlapping in the plan view the first-second pixel circuit portion and the second-second pixel circuit portion and extending in the column direction. The first-first pixel circuit portion and the second-second pixel circuit portion may be electrically connected to the first sub-data line, and the first-second pixel circuit portion and the second-first pixel circuit portion may be electrically connected to the second sub-data line.

## Description

### BACKGROUND

### 1. Technical Field

The present invention relates to a display device.

### 2. Description of the Related Art

A display device includes a display area that displays an image. A plurality of pixel circuit portions including at least a semiconductor pattern, a plurality of data lines for providing data voltages to the plurality of pixel circuit portions, and a plurality of light emitting portions electrically connected to the plurality of pixel circuit portions may be disposed in the display area.

Within the display area, the plurality of pixel circuit portions may be arranged in a matrix form, but the plurality of light emitting portions may not be arranged in a matrix form. For example, the plurality of light emitting portions may be disposed in a Pentile^{®} configuration.

In this case, in order to display high-resolution images with higher space efficiency in a limited display area, various methods are being studied to electrically connect the plurality of pixel circuit portions to the plurality of light emitting portions and simultaneously electrically connect the plurality of pixel circuit portions to the plurality of data lines.

### SUMMARY

The present invention provides a display device capable of displaying high-resolution images.

A display device according to an embodiment of the present invention includes a first-first pixel circuit portion positioned in a first pixel row and a first pixel column, a first-second pixel circuit portion positioned in the first pixel row and a second pixel column, a second-first pixel circuit portion positioned in a second pixel row and the first pixel column, a second-second pixel circuit portion positioned in the second pixel row and the second pixel column, a first sub-data line overlapping the first-first pixel circuit portion and the second-first pixel circuit portion in a plan view and extending in a column direction, and a second sub-data line overlapping the first-second pixel circuit portion and the second-second pixel circuit portion in the plan view and extending in the column direction. Each of the first-first pixel circuit portion and the second-second pixel circuit portion is electrically connected to the first sub-data line, and each of the first-second pixel circuit portion and the second-first pixel circuit portion is electrically connected to the second sub-data line.

In an embodiment, the first-first pixel circuit portion and the first-second pixel circuit portion may be symmetrical to each other, and the second-first pixel circuit portion and the second-second pixel circuit portion may be asymmetrical to each other.

In an embodiment, the first-first pixel circuit portion may include a first-first semiconductor pattern, the first-second pixel circuit portion may include a first-second semiconductor pattern, the second-first pixel circuit portion may include a second-first semiconductor pattern, the second-second pixel circuit portion may include a second-second semiconductor pattern, the first-first semiconductor pattern and the first-second semiconductor pattern may be symmetrical to each other, and the second-first semiconductor pattern and the second-second semiconductor pattern may be asymmetrical to each other.

In an embodiment, each of the first-first semiconductor pattern and the second-second semiconductor pattern may be electrically connected to the first sub-data line, and each of the first-second semiconductor pattern and the second-first semiconductor pattern may be electrically connected to the second sub-data line.

In an embodiment, the display device may further include a first-third pixel circuit portion positioned in the first pixel row and a third pixel column, a first-fourth pixel circuit portion positioned in the first pixel row and a fourth pixel column, a second-third pixel circuit portion positioned in the second pixel row and the third pixel column, a second-fourth pixel circuit portion positioned in the second pixel row and the fourth pixel column, a third sub-data line overlapping the first-third pixel circuit portion and the second-third pixel circuit portion in the plan view and extending in the column direction, and a fourth sub-data line overlapping the first-fourth pixel circuit portion and the second-fourth pixel circuit portion in the plan view ad extending in the column direction. Each of the first-third pixel circuit portion and the second-fourth pixel circuit portion may be electrically connected to the third sub-data line, and each of the first-fourth pixel circuit portion and the second-fourth pixel circuit portion may be electrically connected to the fourth sub-data line.

In an embodiment, the display device may further include a first-first light emitting portion electrically connected to the first-first pixel circuit portion and that emits light of a first color, a first-second light emitting portion electrically connected to the first-second pixel circuit portion and that emits light of a second color, a first-third light emitting portion electrically connected to the first-third pixel circuit portion and that emits light of a third color, and a first-fourth light emitting portion electrically connected to the first-fourth pixel circuit portion and that emits light of the second color.

In an embodiment, the display device may further include a second-first light emitting portion electrically connected to the second-first pixel circuit portion and that emits light of the second color, a second-second light emitting portion electrically connected to the second-second pixel circuit portion and that emits light of the first color, a second-third light emitting portion electrically connected to the second-third pixel circuit portion and that emits light of the second color, and a second-fourth light emitting portion electrically connected to the second-fourth pixel circuit portion and that emits light of the third color.

In an embodiment, the first-first light emitting portion and the first-third light emitting portion may be arranged in a row direction crossing the column direction, the first-second light emitting portion and the first-fourth light emitting portion may be arranged in the row direction and are spaced apart from the first-first light emitting portion and the first-third light emitting portion in the column direction, the second-second light emitting portion and the second-fourth light emitting portion may be arranged in the row direction and are spaced apart from the first-second light emitting portion and the first-fourth light emitting portion in the column direction, and the second-first light emitting portion and the second-third light emitting portion may be arranged in the row direction and are spaced apart from the second-second light emitting portion and the second-fourth light emitting portion in the column direction.

In an embodiment, the display device may further include a first-zeroth dummy pixel circuit portion disposed in a dummy pixel column adjacent to the first pixel row and the first pixel column and spaced apart from the second pixel column, a second-zeroth dummy pixel circuit portion disposed in the second pixel row and the dummy pixel column, a dummy data line disposed on the first-zeroth dummy pixel circuit portion and the second-zeroth dummy pixel circuit portion in the plan view, electrically connected to the second-zeroth dummy pixel circuit portion, and extending in the column direction, and a second-zeroth light emitting portion electrically connected to the second-zeroth dummy pixel circuit portion.

In an embodiment, the second-zeroth light emitting portion, the second-second light emitting portion, and the second-fourth light emitting portion may arranged in the row direction.

In an embodiment, the display device may further include a second-zeroth light emitting portion electrically connected to the first-third pixel circuit portion through the first-third light emitting portion and a connection electrode electrically connecting an anode electrode of the first-third light emitting portion and an anode electrode of the second-zeroth light emitting portion.

In an embodiment, the second-zeroth light emitting portion, the second-second light emitting portion, and the second-fourth light emitting portion may be arranged in the row direction.

A display device according to an embodiment of the present invention includes a plurality of first pixel circuit portions disposed in a row direction along a first pixel row, a plurality of second pixel circuit portions disposed in the row direction along a second pixel row, a plurality of sub-data lines electrically connected to the plurality of first pixel circuit portions and the plurality of second pixel circuit portions, and extending in a column direction crossing the row direction, a plurality of extension lines including a plurality of first extension lines electrically connected one-to-one with the plurality of first pixel circuit portions and a plurality of second extension lines electrically connected one-to-one with the plurality of second pixel circuit portions, a plurality of first light emitting portions electrically connected one-to-one with the plurality of first extension lines, and a plurality of second light emitting portions electrically connected one-to-one with the plurality of second extension lines. The number of the plurality of extension lines overlapping in a plan view a sub-data line disposed in a Nth pixel column among the plurality of sub-data lines is a same as the number of the plurality of extension lines overlapping in the plan view, a sub-data line disposed in a (N+2)th pixel column among the plurality of sub-data lines (where N=4M+1 and M is an integer equal to or greater than 0).

In an embodiment, the plurality of extension lines overlapping in the plan view a sub-data line disposed in the Nth pixel column among the plurality of sub-data lines may also overlap a sub-data line disposed in a (N+1)th pixel column among the plurality of sub-data lines in the plan view.

In an embodiment, the plurality of extension lines overlapping in the plan view the sub-data line disposed in the (N+2)th pixel column among the plurality of sub-data lines may also overlap a sub-data line disposed in a (N+3)th pixel column among the plurality of sub-data lines in the plan view.

In an embodiment, the sub-data line disposed in the Nth pixel column among the plurality of sub-data lines may overlap two second extension lines among the plurality of second extension lines in the plan view.

In an embodiment, the sub-data line disposed in the (N+2)th pixel column among the plurality of sub-data lines may overlap two first extension lines among the plurality of first extension lines in the plan view.

In an embodiment, the sub-data line disposed in the (N+2)th pixel column among the plurality of sub-data lines may overlap two second extension lines among the plurality of second extension lines in the plan view.

In an embodiment, the sub-data line disposed in the (N+2)th pixel column among the plurality of sub-data lines may overlap one second extension line among the plurality of second extension lines and one first extension line among the plurality of first extension lines.

In an embodiment, the sub-data line disposed in the Nth pixel column among the plurality of sub-data lines may overlap two second extension lines among the plurality of second extension lines and one first extension line among the plurality of first extension lines.

In an embodiment, the sub-data line disposed in the (N+2)th pixel column among the plurality of sub-data lines may overlap one first extension line among the plurality of first extension lines and two second extension lines among the plurality of second extension lines.

In an embodiment, the sub-data line disposed in the (N+2)th pixel column among the plurality of sub-data lines may overlap two first extension lines among the plurality of first extension lines and one second extension line among the plurality of second extension lines.

In an embodiment, the sub-data line disposed in the Nth pixel column among the plurality of sub-data lines may overlap two first extension lines among the plurality of first extension lines and two second extension lines among the plurality of second extension lines.

In an embodiment, the sub-data line disposed in the (N+2)th pixel column among the plurality of sub-data lines may overlap two first extension lines among the plurality of first extension lines and two second extension lines among the plurality of second extension lines.

A display device according to embodiments may include a first-first pixel circuit portion positioned in a first pixel row and a first pixel column, a first-second pixel circuit portion positioned in the first pixel row and a second pixel column, a second-first pixel circuit portion positioned in a second pixel row and the first pixel column, a second-second pixel circuit portion positioned in the second pixel row and the second pixel column, a first sub-data line overlapping the first-first pixel circuit portion and the second-first pixel circuit portion in a plan view and extending in a column direction, and a second sub-data line overlapping the first-second pixel circuit portion and the second-second pixel circuit portion in the plan view ad extending in the column direction. Each of the first-first pixel circuit portion and the second-second pixel circuit portion may be electrically connected to the first sub-data line, and each of the first-second pixel circuit portion and the second-first pixel circuit portion may be electrically connected to the second sub-data line.

Accordingly, within the limited display area, the first-first pixel circuit portion, the first-second pixel circuit portion, the second-first pixel circuit portion, the second-second pixel circuit portion, the first sub-data line, and the second sub-data line may be disposed efficiently.

A display device according to embodiments may include a plurality of first pixel circuit portions disposed in a row direction along a first pixel row, a plurality of second pixel circuit portions disposed in the row direction along a second pixel row, a plurality of sub-data lines electrically connected to the plurality of first pixel circuit portions and the plurality of second pixel circuit portions, and extending in a column direction crossing the row direction, a plurality of extension lines including a plurality of first extension lines electrically connected one-to-one with the plurality of first pixel circuit portions and a plurality of second extension lines electrically connected one-to-one with the plurality of second pixel circuit portions, a plurality of first light emitting portions electrically connected one-to-one with the plurality of first extension lines, and a plurality of second light emitting portions electrically connected one-to-one with the plurality of second extension lines. The number of the plurality of extension lines overlapping in a plan view a sub-data line disposed in a Nth pixel column among the plurality of sub-data lines may be a same as the number of the plurality of extension lines overlapping in the plan view a sub-data line disposed in a (N+2)th pixel column among the plurality of sub-data lines (where N=4M+1 and M is an integer equal to or greater than 0).

Accordingly, in each of the plurality of sub-data lines, the coupling influence due to the plurality of extension lines may be at substantially the same level.

### BRIEF DESCRIPTION OF THE DRAWINGS

Illustrative, non-limiting embodiments will be more clearly understood from the following detailed description in conjunction with the accompanying drawings.
FIG. 1 is a plan view for explaining a display device according to a first embodiment of the present invention.
FIG. 2 is an enlarged plan view of area A of FIG. 1.
FIG. 3 is a cross-sectional view for explaining a first-first light emitting portion shown in FIG. 2.
FIGS. 4, 5, 6, and 7 are views for explaining a first-first pixel circuit portion, a first-second pixel circuit portion, a first sub-data line, and a second sub-data line shown in FIG. 2.
FIGS. 8, 9, 10, and 11 are views for explaining a second-first pixel circuit portion, a second-second pixel circuit portion, a first sub-data line, and a second sub-data line shown in FIG. 2.
FIG. 12 is a plan view for explaining a display device according to a second embodiment of the present invention.
FIG. 13 is an enlarged plan view of area B of FIG. 12.
FIG. 14 is a plan view for explaining a display device according to a third embodiment of the present invention.
FIG. 15 is an equivalent circuit diagram showing one pixel.
FIG. 16 is a plan view for explaining pixel circuit portions and sub-data lines disposed in area C of FIG. 14.
FIG. 17 is a plan view for explaining extension lines disposed in area C of FIG. 14.
FIG. 18 is an enlarged plan view of area C of FIG. 14.
FIG. 19 is a cross-sectional view taken along line V-V' of FIG. 18.
FIG. 20 is a plan view for explaining a display device according to a fourth embodiment of the present invention.
FIGS. 21, 22, 23, 24, 25, 26, and 27 are plan views for explaining various embodiments of extension lines disposed in area D of FIG. 20.

### DETAILED DESCRIPTION OF THE EMBODIMENTS

Hereinafter, a display device according to embodiments of the present invention will be explained in detail with reference to the accompanying drawings. The same reference numerals are used for the same components in the drawings, and redundant descriptions of the same components will be omitted.

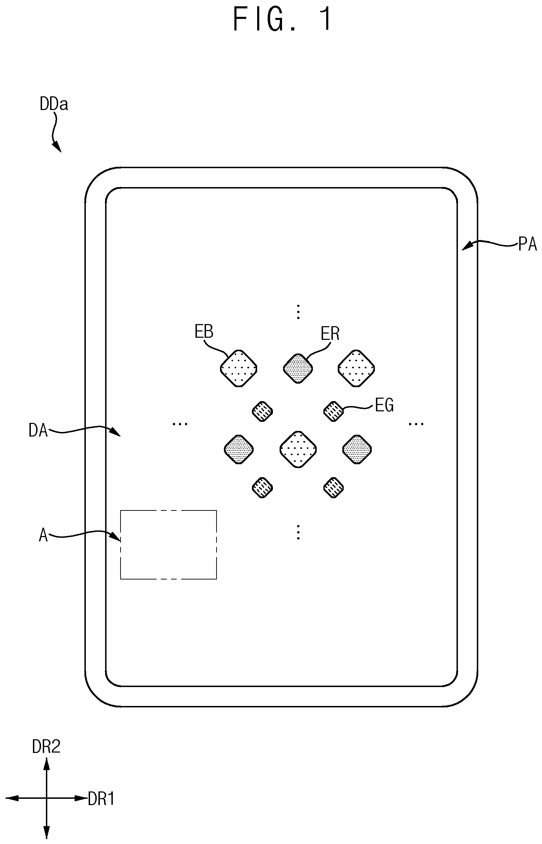

FIG. 1 is a plan view for explaining a display device according to a first embodiment of the present invention.

Referring to FIG. 1, a display device DDa according to the first embodiment of the present invention may include a display area DA and a peripheral area PA.

The display area DA may be an area that displays an image. To this end, a plurality of light emitting portions may be disposed in the display area DA. For example, the plurality of light emitting portions may include a first color emitting portion EB, a second color emitting portion EG, and a third color emitting portion ER.

The first color light emitting portion EB may emit light that is visible as a first color to the user of the display device DDa. The second color light emitting portion EG may emit light that is visible as a second color to the user of the display device DDa. The third color light emitting portion ER may emit light that is visible as a third color to the user of the display device DDa. In some embodiments, the first color may be blue, the second color may be green, and the third color may be red. However, the present invention is not limited to these color assignments, and the first color, the second color, and the third color may have various combinations of three different colors.

In an embodiment, a plurality of first color light emitting portions EB, a plurality of second color light emitting portions EG, and a plurality of third color light emitting portions ER may each be provided. The first color light emitting portions EB and the third color light emitting portions ER may be alternately arranged along a row direction DR1, and the second color light emitting portions EG may be arranged along the row direction DR1. In this case, the first color light emitting portions EB and the third color light emitting portions ER arranged alternately along the row direction DR1 may be alternately arranged in a column direction crossing the row direction DR1 with the second color light emitting portions EG arranged along the row direction DR1. As such, the planar arrangement of the first color light emitting portion EB, the second color light emitting portion EG, and the third color light emitting portion ER shown in FIG. 1 may be referred to as a Pentile^{®} configuration.

The peripheral area PA may be disposed on at least one side of the display area DA. The peripheral area PA may surround the display area DA. A plurality of driving circuits that generate or transmit driving signals provided to the plurality of light emitting portions may be disposed in the peripheral area PA.

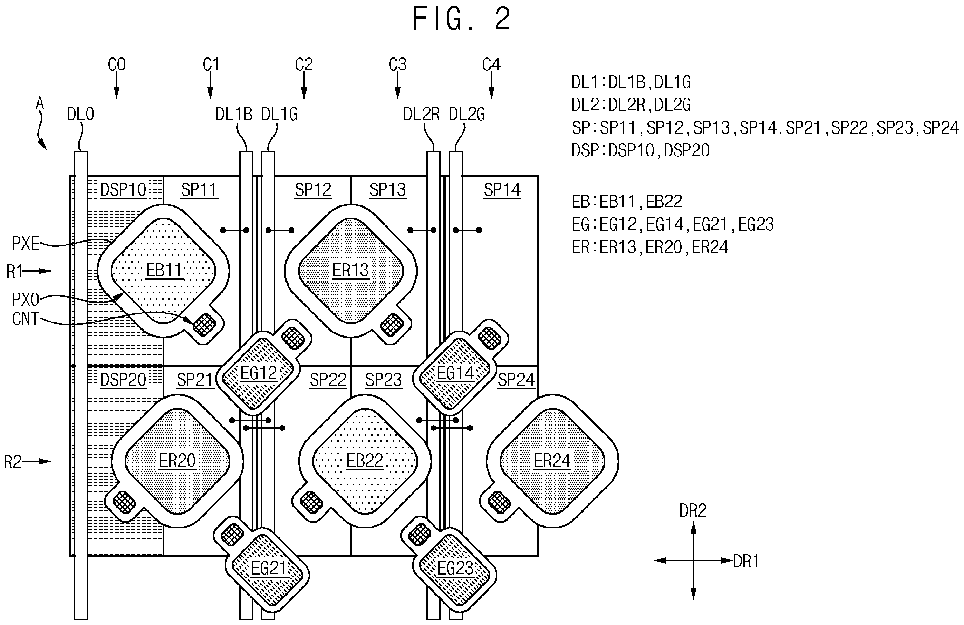

FIG. 2 is an enlarged plan view of area A of FIG. 1. The area A may be part of the display area DA.

Referring to FIG. 2, a plurality of pixel circuit portions SP and a plurality of dummy pixel circuit portions DSP may be disposed in the display area DA.

In an embodiment, the plurality of pixel circuit portions SP may be arranged in a matrix form. For example, the plurality of pixel circuit portions SP may include a first-first pixel circuit portion SP11, a first-second pixel circuit portion SP12, a first-third pixel circuit portion SP13, a first-fourth pixel circuit portion SP14, a second-first pixel circuit portion SP21, a second-second pixel circuit portion SP22, a second-third pixel circuit portion SP23, and a second-fourth pixel circuit portion SP24 disposed in a matrix of two rows and four columns.

The first-first pixel circuit portion SP11, the first-second pixel circuit portion SP12, the first-third pixel circuit portion SP13, and the first-fourth pixel circuit portion SP14 may be disposed in a first pixel row R1. The first-first pixel circuit portion SP11, the first-second pixel circuit portion SP12, the first-third pixel circuit portion SP13, and the first-fourth pixel circuit portion SP14 may be arranged in the row direction DR1.

The second-first pixel circuit portion SP21, the second-second pixel circuit portion SP22, the second-third pixel circuit portion SP23, and the second-fourth pixel circuit portion SP24 may be disposed in a second pixel row R2. The second pixel row R2 may be adjacent to the first pixel row R1 in the column direction DR2. The second-first pixel circuit portion SP21, the second-second pixel circuit portion SP22, the second-third pixel circuit portion SP23, and the second-fourth pixel circuit portion SP24 may be arranged in the row direction DR1.

The first-first pixel circuit portion SP11 and the second-first pixel circuit portion SP21 may be disposed in a first pixel column C1. The first-first pixel circuit portion SP11 and the second-first pixel circuit portion SP21 may be arranged adjacently to each other in the column direction DR2.

The first-second pixel circuit portion SP12 and the second-second pixel circuit portion SP22 may be disposed in a second pixel column C2. The second pixel column C2 may be adjacent to the first pixel column C1 in the row direction DR1. The first-second pixel circuit portion SP12 and the second-second pixel circuit portion SP22 may be arranged adjacently to each other in the column direction DR2.

The first-third pixel circuit portion SP13 and the second-third pixel circuit portion SP23 may be disposed in a third pixel column C3. The third pixel column C3 may be adjacent to the second pixel column C2 in the row direction DR1. The first-third pixel circuit portion SP13 and the second-third pixel circuit portion SP23may be arranged adjacently to each other in the column direction DR2.

The first-fourth pixel circuit portion SP14 and the second-fourth pixel circuit portion SP24 may be disposed in a fourth pixel column C4. The fourth pixel column C4 may be adjacent to the third pixel column C3 in the row direction DR1. The first-fourth pixel circuit portion SP14 and the second-fourth pixel circuit portion SP24 may be arranged adjacently to each other in the column direction DR2.

The plurality of dummy pixel circuit portions DSP may include a first-zeroth dummy pixel circuit portion DSP10 and a second-zeroth dummy pixel circuit portion DSP20.

The first-zeroth dummy pixel circuit portion DSP10 may be disposed in the first pixel row R1. The second-zeroth dummy pixel circuit portion DSP20 may be disposed in the second pixel row R2.

The first-zeroth dummy pixel circuit portion DSP10 and the second-zeroth dummy pixel circuit portion DSP20 may be disposed in a dummy pixel column C0. The dummy pixel column C0 may be adjacent to the first pixel column C1 in the row direction DR1. In this case, the dummy pixel column C0 may be arranged closer to the peripheral area PA than the first pixel column C1. The first-zeroth dummy pixel circuit portion DSP10 and the second-zeroth dummy pixel circuit portion DSP20 may be arranged in the column direction DR2.

A first data line pair DL1 and a second data line pair DL2 may overlap the plurality of pixel circuit portions SP. The first data line pair DL1 may include a first sub-data line DL1B and a second sub-data line DL1G. The second data line pair DL2 may include a third sub-data line DL2R and a fourth sub-data line DL2G.

The first sub-data line DL1B may be disposed in the first pixel column C1. That is, the first sub-data line DL1B may overlap the first-first pixel circuit portion SP11 and the second-first pixel circuit portion SP21 in a plan view. The first sub-data line DL1B may extend in the column direction DR2.

The second sub-data line DL1G may be disposed in the second pixel column C2. That is, the second sub-data line DL1G may overlap the first-second pixel circuit portion SP12 and the second-second pixel circuit portion SP22 in the plan view. The second sub-data line DL1G may extend in the column direction DR2.

The third sub-data line DL2R may be disposed in the third pixel column C3. That is, the third sub-data line DL2R may overlap the first-third pixel circuit portion SP13 and the second-third pixel circuit portion SP23 in the plan view. The third sub-data line DL2R may extend in the column direction DR2.

The fourth sub-data line DL2G may be disposed in the fourth pixel column C4. That is, the fourth sub-data line DL2G may overlap the first-fourth pixel circuit portion SP14 and the second-fourth pixel circuit portion SP24 in the plan view. The fourth sub- data line DL2G may extend in the column direction DR2.

The first sub-data line DL1B may be electrically connected to each of the first-first pixel circuit portion SP11 and the second-second pixel circuit portion SP22. In an embodiment, a first color data voltage corresponding to the first color may be provided to the first sub-data line DL1B.

The second sub-data line DL1G may be electrically connected to each of the first-second pixel circuit portion SP12 and the second-first pixel circuit portion SP21. In an embodiment, a second color data voltage corresponding to the second color may be provided to the second sub-data line DL1G.

The third sub-data line DL2R may be electrically connected to each of the first-third pixel circuit portion SP13 and the second-fourth pixel circuit portion SP24. In an embodiment, a third color data voltage corresponding to the third color may be provided to the third sub-data line DL2R.

The fourth sub-data line DL2G may be electrically connected to each of the first-fourth pixel circuit portions SP14 and the second-third pixel circuit portions SP23. In an embodiment, a second color data voltage corresponding to the second color may be provided to the fourth sub-data line DL2G.

A dummy data line DL0 may be disposed on the plurality of dummy pixel circuit portions DSP. The dummy data line DL0 may be disposed in the dummy pixel column C0. That is, the dummy data line DL0 may overlap the first-zeroth dummy pixel circuit portion DSP10 and the second-zeroth dummy pixel circuit portion DSP20 in the plan view. The dummy data line DL0 may extend in the column direction DR2. In an embodiment, the dummy data line DL0 may be electrically connected to the second-zeroth dummy pixel circuit portion DSP20.

The first color light emitting portion EB, the second color light emitting portion EG, and the third color light emitting portion ER may be disposed in the display area DA. The first color light emitting portion EB, the second color light emitting portion EG, and the third color light emitting portion ER may be disposed on the plurality of pixel circuit portions SP, the plurality of dummy pixel circuit portions DSP, the dummy data line DL0, the first data line pair DL1, and the second data line pair DL2.

The first color light emitting portion EB may include a first-first light emitting portion EB11 electrically connected to the first-first pixel circuit portion SP11 and a second-second light emitting portion EB22 electrically connected to the second-second pixel circuit portion SP22.

The second color light emitting portion EG may include a first-second light emitting portion EG12 electrically connected to the first-second pixel circuit portion SP12, a first-fourth light emitting portion EG14 electrically connected to the first-fourth pixel circuit portion SP14, a second-first light emitting portion EG21 electrically connected to the second-first pixel circuit portion SP21, and a second-third light emitting portion EG23 electrically connected to the second-third pixel circuit portion SP23.

The third color light emitting portion ER may include a first-third light emitting portion ER13 electrically connected to the first-third electrically connected to the first-third pixel circuit portion SP13, a second-zeroth light emitting portion ER20 electrically connected to the second-zeroth dummy pixel circuit portion DSP20, and a second-fourth light emitting portion ER24 electrically connected to the second-fourth pixel circuit portion SP24.

The first color light emitting portion EB, the second color light emitting portion EG, and the third color light emitting portion ER may include substantially similar structures. For example, if the description is based on the first-first light emitting portion EB11, the first-first light emitting portion EB11 may include a pixel electrode PXE, and the pixel electrode PXE may be electrically connected to the first-first pixel circuit portion SP11 through a contact hole CNT.

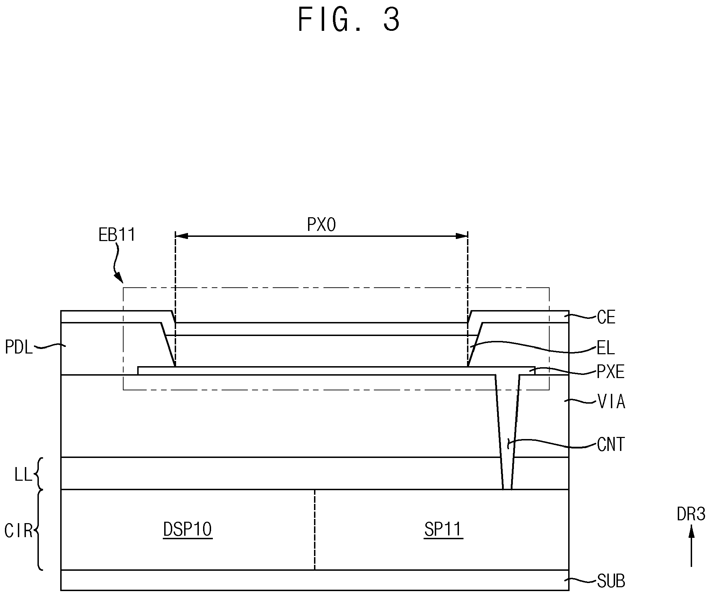

In this case, a part of the pixel electrode PXE may be exposed by a pixel opening PXO, and a light emitting layer that emits light of the first color may be disposed on the part of the pixel electrode PXE. This will be described in detail later with reference to FIG. 3.

The first color light emitting portion EB, the second color light emitting portion EG, and the third color light emitting portion ER may be disposed in a Pentile^{®} configuration.

The first-first light emitting portion EB11 and the first-third light emitting portion ER13 may be disposed adjacently in the row direction DR1. In this case, light of the first color may be emitted from the first-first light emitting portion EB11, and light of the third color may be emitted from the first-third light emitting portion ER13.

The first-second light emitting portion EG12 and the first-fourth light emitting portion EG14 may be disposed in the row direction DR1, and be spaced apart from the first-first light emitting portion EB11 and the first-third light emitting portion ER13 in the column direction DR2. Light of the second color may be emitted from each of the first-second light emitting portion EG12 and the first-fourth light emitting portion EG14.

The second-zeroth light emitting portion ER20, the second-second light emitting portion EB22, and the second-fourth light emitting portion ER24 may be disposed adjacent to one another in the row direction DR1, and be spaced apart from the first-second light emitting portion EG12 and the first-fourth light emitting portion EG14 in the column direction DR2. Light of the third color light may be emitted from each of the second-zeroth light emitting portion ER20 and the second-fourth light emitting portion ER24, and light of the first color may be emitted from the second-second light emitting portion.

The second-first light emitting portion EG21 and the second-third light emitting portion EG23 may be disposed in the row direction DR1, and be space apart from the second-zeroth light emitting portion ER20, the second-second light emitting portion EB22, and the second-fourth light emitting portion ER24 in the column direction DR2.

In the display device DDa according to the first embodiment of the present invention, the plurality of pixel circuit portions SP and the plurality of dummy pixel circuit parts DSP may be disposed in a matrix form. However, the first color light emitting portion EB, the second color light emitting portion EG, and the third color light emitting portion ER electrically connected to the plurality of pixel circuit portions SP and the plurality of dummy pixel circuit portions DSP may be disposed in a Pentile^{®} configuration.

In order to electrically connect the plurality of pixel circuit portions SP and the plurality of dummy pixel circuit portions DSP disposed in a matrix configuration to the first color light emitting potion EB, the second light emitting potion EG, and third light emitting potion ER, in the present invention, pixel circuit portions connected to one sub-data line may not be aligned in the column direction. For example, in the first pixel row R1, the first sub-data line DL1B may be electrically connected to the first-first pixel circuit portion SP11 positioned in the first pixel column C1, but the second pixel row R2, the first sub-data line DL1B may be electrically connected to the second-second pixel circuit part SP22 positioned in the second pixel column C2.

Although FIG. 2 shows only the area A of the display area DA as shown in FIG. 1, components disposed in area A shown in FIG. 2 may be applied to the entire display area DA. More specifically, the components shown in FIG. 2 may be repeatedly arranged in the column direction DR2. In addition, among the components shown in FIG. 2, except for the dummy pixel circuit portion DSP, the dummy data line DL0, and the second-zeroth light emitting portion ER20, the components may be repeatedly arranged in the row direction DR1.

FIG. 3 is a cross-sectional view for explaining a first-first light emitting portion shown in FIG. 2.

Referring to FIG. 3, the display device DDa according to the first embodiment of the present invention may include a substrate SUB, a circuit layer CIR, a line layer LL, a via insulating layer VIA, a pixel electrode PXE, a pixel defining layer PDL, a light emitting layer EL, and a common electrode layer CE, which aredisposed in a thickness direction DR3 perpendicular to the row direction DR1 and the column direction DR2, respectively.

The substrate SUB may include glass, plastic, or the like. In an embodiment, the substrate SUB may include a flexible material.

The circuit layer CIR may be disposed on the substrate SUB. The circuit layer CIR may include at least one transistor and may include the plurality of pixel circuit portions SP. For example, as shown in FIG. 3, the circuit layer CIR may include the first-zeroth dummy pixel circuit portion DSP10 and the first-first pixel circuit portion SP11.

The line layer LL may be disposed on the circuit layer CIR. The line layer LL may include at least a data line. For example, although not shown in FIG. 3, the line layer LL may include the dummy data line DL0, the first data line pair DL1, and the second data line pair DL2.

The via insulating layer VIA may be disposed on the line layer LL. The via insulating layer VIA may include an organic insulating material and/or an inorganic insulating material. An upper surface of the via insulating layer VIA may be substantially flat.

The pixel electrode PXE may be disposed on the via insulating layer VIA. The pixel electrode PXE may include a conductive material. The pixel electrode PXE may be electrically connected to the first-first pixel circuit portion SP11 of the circuit layer CIR through at least a through hole CNT penetrating the via insulating layer VIA. For example, as shown in FIG. 3, the pixel electrode PXE may be electrically connected to the first-first pixel circuit portion SP11 through the through hole CNT extending through the via insulating layer VIA and the line layer LL. In some embodiments, unlike shown in FIG. 3, the pixel electrode PXE may be electrically connected to a bridge electrode included in the line layer LL through the through hole CNT, and the bridge electrode may be electrically connected to the first-first pixel circuit portion SP11. In an embodiment, the pixel electrode PXE may be an anode electrode.

The pixel defining layer PDL may be disposed on the via insulating layer VIA and the pixel electrode PXE. The pixel defining layer PDL may define a pixel opening PXO that exposes at least a part of the pixel electrode PXE. The pixel defining layer PDL may include an organic insulating material and/or an inorganic insulating material.

The light emitting layer EL may be disposed on the part of the pixel electrode PXE exposed by the pixel opening PXO. In an embodiment, the light emitting layer EL may include an organic light emitting material.

The common electrode layer CE may be disposed on the light emitting layer EL. The common electrode layer CE may include a conductive material. In an embodiment, the common electrode layer CE may be a cathode electrode.

The pixel electrode PXE, the light emitting layer EL, and the common electrode layer CE may define the first-first light emitting portion EB11.

In FIG. 3, only the first-first light emitting portion EB11 is shown. However, each of the other light emitting portions (e.g., the first-second light emitting portion EG12, the first-third light emitting portion ER13, the first-fourth light emitting portion ER14, the second-zeroth light emitting portion ER20, the second-first light emitting portion EG21, the second-second light emitting portion EB22, the second-third light emitting portion EG23, and the second-fourth light emitting portion ER24 of FIG. 2) not shown in FIG. 3 may have a structure substantially similar to the first-first light emitting portion EB11 shown in FIG. 3.

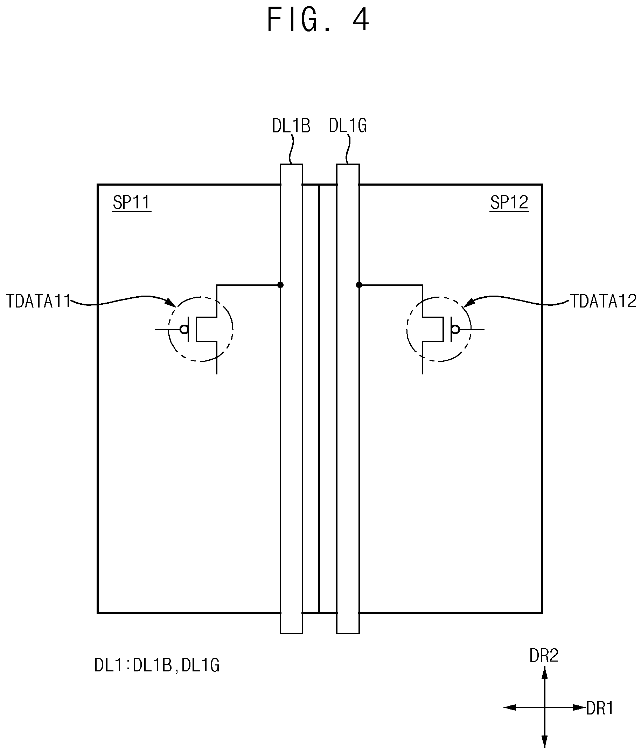

FIGS. 4, 5, 6, and 7 are views for explaining a first-first pixel circuit portion, a first-second pixel circuit portion, a first sub-data line, and a second sub-data line shown in FIG. 2.

Referring to FIG. 4, the first-first pixel circuit portion SP11 may include a first-first data write transistor TDATA11 electrically connected to the first sub-data line DL1B, and the first-second pixel circuit portion SP12 may include a first-second data write transistor TDATA12 electrically connected to the second sub-data line DL1G.

In an embodiment, an input terminal of the first-first data writing transistor TDATA11 may be directly connected to the first sub-data line DL1B without passing through another transistor.

In an embodiment, an input terminal of the first-second data writing transistor TDATA12 may be directly connected to the second sub-data line DL1G without passing through another transistor.

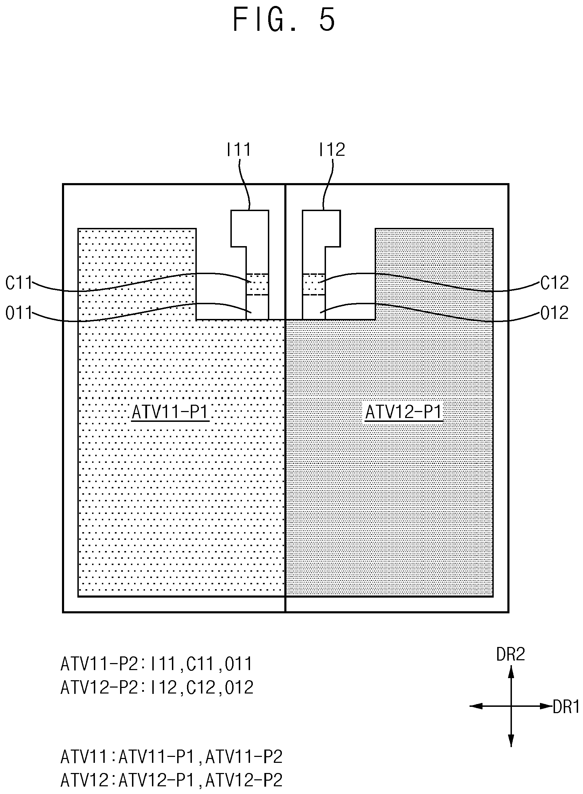

Referring to FIG. 5, the first-first pixel circuit portion SP11 may include a first-first semiconductor pattern ATV11, and the first-second pixel circuit portion SP12 may include a first-second semiconductor pattern ATV21.

The first-first semiconductor pattern ATV11 may include a first part ATV11-P1 and a second part ATV11-P2.

The second part ATV11-P2 of the first-first semiconductor pattern ATV11 may include conductive regions I11 and O11 and a semiconductor region C11. The conductive region I11 may be the input terminal of the first-first data writing transistor TDATA11, or may be electrically connected to the input terminal of the first-first data writing transistor TDATA11. The semiconductor region C11 may define a channel of the first-first data writing transistor TDATA11. The conductive region O11 may be an output terminal of the first-first data writing transistor TDATA11, or may be electrically connected to the output terminal of the first-first data writing transistor TDATA11.

The first part ATV11-P1 of the first-first semiconductor pattern ATV1 1 may be a part of the first-first semiconductor pattern ATV11 excluding the second part ATV11-P2 of the first-first semiconductor pattern ATV11. In this case, the first part ATV11-P1 of the first-first semiconductor pattern ATV11 may have various known shapes.

The first-second semiconductor pattern ATV12 may include a first part ATV12-P1 and a second part ATV12-P2.

The second part ATV12-P2 of the first-second semiconductor pattern ATV12 may include conductive regions I12 and 012 and a semiconductor region C12. The conductive region I12 may be the input terminal of the first-second data writing transistor TDATA12, or may be electrically connected to the input terminal of the first-second data writing transistor TDATA12. The semiconductor region C12 may define a channel of the first-second data writing transistor TDATA12. The conductive region 012 may be the output terminal of the first-second data writing transistor TDATA12, or may be electrically connected to the output terminal of the first-second data writing transistor TDATA12.

The first part ATV12-P1 of the first-second semiconductor pattern ATV12 may be a part of the first-second semiconductor pattern ATV12 excluding the second part ATV12-P2 of the first-second semiconductor pattern ATV12. In this case, the first part ATV12-P1 of the first-second semiconductor pattern ATV12 may have various known shapes.

In an embodiment, the first-first semiconductor pattern ATV11 and the first-second semiconductor pattern ATV12 may be symmetrical to each other with respect to an imaginary line extending between them. That is, the first part ATV11-P1 of the first-first semiconductor pattern ATV11 may be symmetrical the first part ATV12-P1 of the first-second semiconductor pattern ATV12, and the second part ATV11-P2 of the semiconductor pattern ATV11 may be symmetrical to the second part ATV12-P2 of the first-second semiconductor pattern ATV12.

In an embodiment, the first-first semiconductor pattern ATV11 and the first-second semiconductor pattern ATV12 may be physically connected to each other. For example, at least a part of the first part ATV11-P1 of the first-first semiconductor pattern ATV11 may be physically connected to at least a part of the first part ATV12-P1 of the first-second semiconductor pattern ATV12.

In an embodiment, the first-first semiconductor pattern ATV11 and the first-second semiconductor pattern ATV12 may be symmetrical to each other, and at the same time, the first-first semiconductor pattern ATV11 and the first-second semiconductor pattern ATV12 may be physically connected to each other.

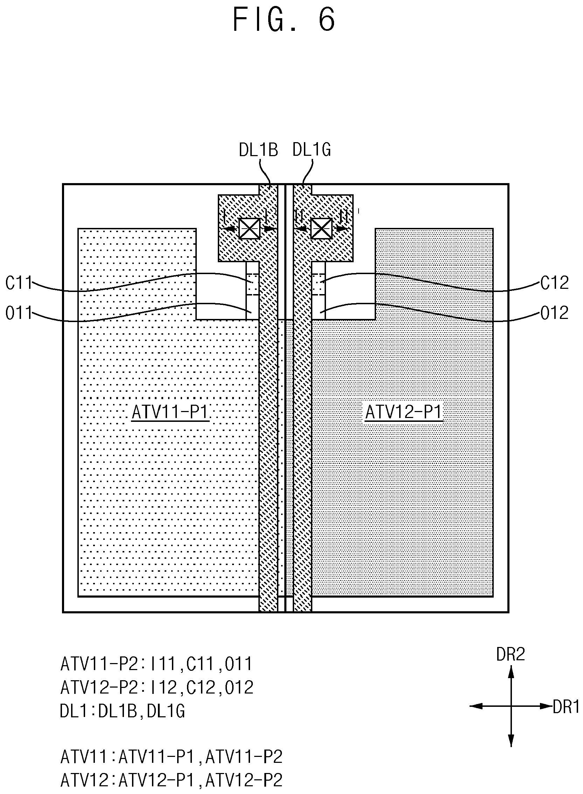

Referring to FIG. 6, the first data line pair DL1 may be disposed on the first-first semiconductor pattern ATV11 and the first-second semiconductor pattern ATV12.

The first sub data line DL1B may be electrically connected to the second part AT V11-P2 of the first-first semiconductor pattern ATV11. More specifically, the first sub-data line DL1B may be electrically connected to the conductive region I11 of the first-first semiconductor pattern ATV11.

The second sub-data line DL1G may be electrically connected to the second part ATV12-P2 of the first-second semiconductor pattern ATV12. More specifically, the second sub-data line DL1G may be electrically connected to the conductive region I12 of the first-second semiconductor pattern ATV12.

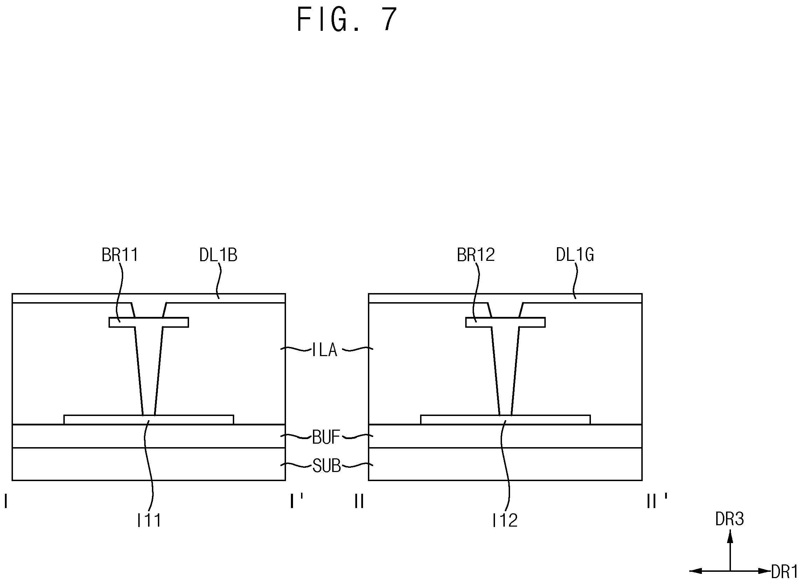

Referring to FIG. 7, FIG. 7 is a cross-sectional view taken along lines I-I' and II-II' of FIG. 6.

A buffer layer BUF may be disposed on the substrate SUB. The buffer layer BUF may be included in the circuit layer CIR described with reference to FIG. 3. The buffer layer BUF may include an inorganic insulating material. The buffer layer BUF may serve to protect components disposed on the buffer layer BUF from foreign substances present on the substrate SUB. In an embodiment, the buffer layer BUF may be omitted.

The first-first semiconductor pattern ATV11 and the first-second semiconductor pattern ATV12 may be disposed on the buffer layer BUF. For example, as shown in FIG. 7, the conductive region I11 of the first-first semiconductor pattern ATV11 may be disposed on the buffer layer BUF, and the conductive region I12 of the first-second semiconductor pattern ATV12 may be disposed on the buffer layer BUF.

An insulating layer array ILA may be disposed on the buffer layer BUF. The insulating layer array ILA may cover the conductive region I11 of the first-first semiconductor pattern ATV11 and the conductive region I12 of the first-second semiconductor pattern ATV12. The insulating layer array ILA may include a plurality of insulating layers stacked in the thickness direction DR3. The insulating layer array ILA may be included in the circuit layer CIR and the line layer LL described with reference to FIG. 3.

The first sub-data line DL1B and the second sub-data line DL1G may be disposed on the insulating layer array ILA. In this case, the first sub-data line DL1B may be disposed to overlap at least a part of the conductive region I11 of the first-first semiconductor pattern ATV11, and the second sub-data line DL1G may be disposed on at least a part of the conductive region I12 of the first-second semiconductor pattern ATV12.

The first sub-data line DL1B may be electrically connected to the conductive region I11 of the first-first semiconductor pattern ATV11.

For example, as shown in FIG. 7, the first sub-data line DL1B may electrically contact a first-first bridge electrode BR11, and the first-first bridge electrode BR11may electrically contact the conductive region I11 of the first-first semiconductor pattern ATV11. In this case, the first-first bridge electrode BR11may be disposed between the first sub-data line DL1B and the first-first semiconductor pattern ATV11 in the circuit layer CIR and the line layer LL.

In some embodiments, unlike shown in FIG. 7, the first sub-data line DL1B may electrically contact the conductive region I11 of the 1-1 semiconductor pattern ATV11 through two or more bridge electrodes. In some embodiments, the first-first bridge electrode BR11 may be omitted, and the first sub-data line DL1B may electrically contact the conductive region I11 of the first-first semiconductor pattern ATV11.

The second sub-data line DL1G may be electrically connected to the conductive region I12 of the first-second semiconductor pattern ATV12.

For example, as shown in FIG. 7, the first sub-data line DL1G may electrically contact a first-second bridge electrode BR12, and the first-second bridge electrode BR12 may electrically contact the conductive region I12 of the first-second semiconductor pattern ATV12. In this case, the first-second bridge electrode BR12may be disposed between the second sub-data line DL1G and the first-second semiconductor pattern ATV12 in the circuit layer CIR and the line layer LL.

Unlike in FIG. 7, the second sub-data line DL1G may electrically contact the conductive region I12 of the first-second semiconductor pattern ATV12 through two or more bridge electrodes. For example, the first-second bridge electrode BR12 may be omitted, and the second sub-data line DL1G may electrically contact the conductive region I12 of the first-second semiconductor pattern ATV12.

In FIGS. 4, 5, 6, and 7, only the first-first pixel circuit portion SP11, the first-second pixel circuit portion SP12, the first sub-data line DL1B, and the second sub-data line DL1G are described, the contents described with reference to FIGS. 4, 5, 6, and 7 may be similar applied to the first-third pixel circuit portion SP13, the first-fourth pixel circuit portion SP14, the third sub-data line DL2R, and the fourth sub-data line DL2G. That is, the first-third pixel circuit portion SP13, the first-fourth pixel circuit portion SP14, the third sub-data line DL2R, and the fourth sub-data line DL2G may have substantially the same structure as the first-first pixel circuit portion SP11, the first-second pixel circuit portion SP12, the first sub-data line DL1B, and the second sub-data line DL1G.

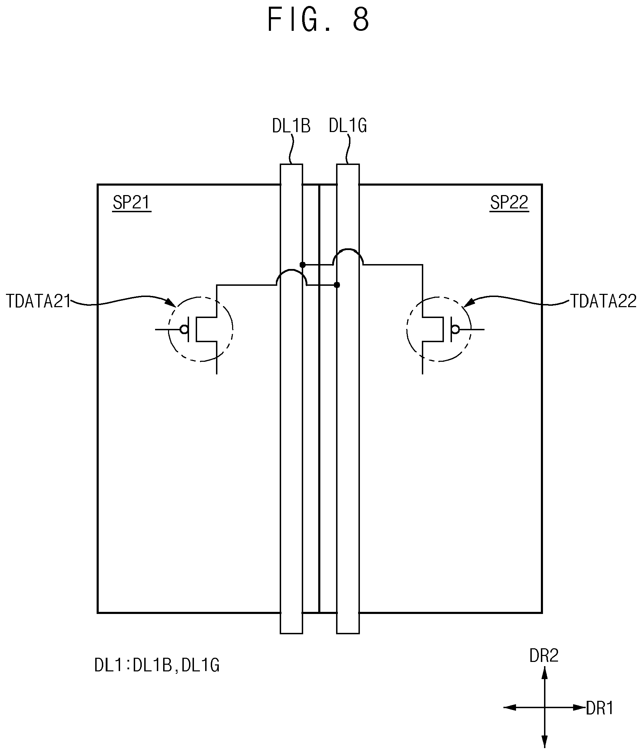

FIGS. 8, 9, 10, and 11 are views for explaining a second-first pixel circuit portion, a second-second pixel circuit portion, a first sub-data line, and a second sub-data line shown in FIG. 2.

Referring to FIG. 8, the second-first pixel circuit portion SP21 may include a second-first data write transistor TDATA21 electrically connected to the second sub-data line DL1G, and the second-second pixel circuit portion SP22 may include a second-second data write transistor TDATA22 electrically connected to the first sub-data line DL1B.

In an embodiment, an input terminal of the second-first data writing transistor TDATA21 may be directly connected to the second sub-data line DL1G without passing through another transistor.

In an embodiment, the input terminal of the second-second data writing transistor TDATA22 may be directly connected to the first sub-data line DL1B without passing through another transistor.

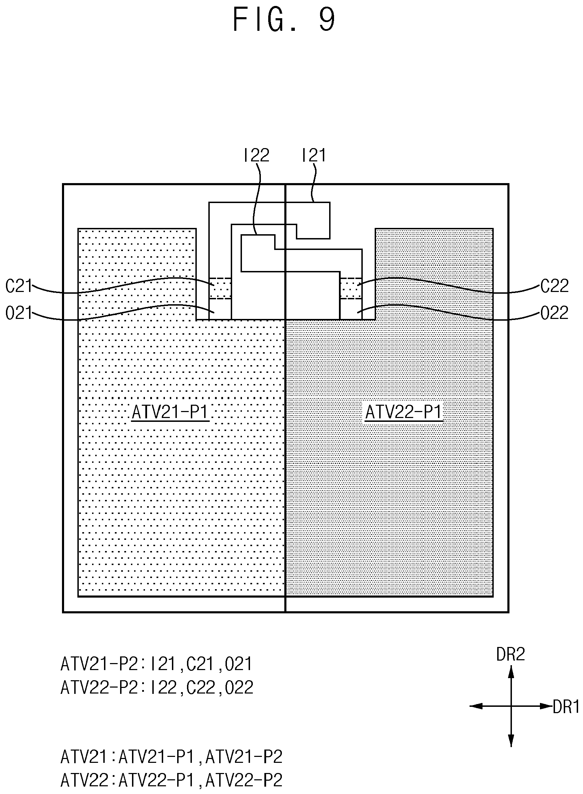

Referring to FIG. 9, the second-first pixel circuit portion SP21 may include a second-first semiconductor pattern ATV21, and the second-second pixel circuit portion SP22 may include a second-second semiconductor pattern ATV22.

The second-first semiconductor pattern ATV21 may include a first part ATV21-P1 and a second part ATV21-P2.

The second part ATV21-P2of the second-first semiconductor pattern ATV21 may include conductive regions I21 and 021 and a semiconductor region C21. The conductive region I21 may be the input terminal of the second-first data writing transistor TDATA21, or may be electrically connected to the input terminal of the second-first data writing transistor TDATA21. The semiconductor region C21 may define a channel of the second-first data writing transistor TDATA21. The conductive region 021 may be an output terminal of the second-first data writing transistor TDATA21, or may be electrically connected to the output terminal of the second-first data writing transistor TDATA21.

The first part ATV21-P1 of the second-first semiconductor pattern ATV21 may be a part of the second-first semiconductor pattern ATV21 excluding the second part ATV21-P2 of the second-first semiconductor pattern ATV21. In this case, the first part ATV21-P1 of the second-first semiconductor pattern ATV21 may have various known shapes.

The second-second semiconductor pattern ATV22 may include a first part ATV22-P1 and a second part ATV22-P2.

The second part ATV22-P2 of the second-second semiconductor pattern ATV22 may include conductive regions I22 and O22 and a semiconductor region C22. The conductive region I22 may be the input terminal of the second-second data writing transistor TDATA22, or may be electrically connected to the input terminal of the second-second data writing transistor TDATA22. The semiconductor region C22 may define a channel of the second-second data writing transistor TDATA22. The conductive region O22 may be an output terminal of the second-second data writing transistor TDATA22, or may be electrically connected to the output terminal of the second-second data writing transistor TDATA22.

The first part ATV22-P1 of the second-second semiconductor pattern ATV22 may be a part of the second-second semiconductor pattern ATV22 excluding the second part ATV22-P2 of the second-second semiconductor pattern ATV22. In this case, the first part ATV22-P1 of the second-second semiconductor pattern ATV22 may have various known shapes.

In an embodiment, the second-first semiconductor pattern ATV21 and the second-second semiconductor pattern ATV22 may be asymmetrical to each other. For example, as shown in FIG. 9, the second part ATV21-P2 of the second-first semiconductor pattern ATV21 and the second part ATV22-P2 of the second-second semiconductor pattern ATV22 may be asymmetrical to each other.

In an embodiment, the first part ATV21-P1 of the second-first semiconductor pattern ATV21 and the first part ATV22-P1 of the second-second semiconductor pattern ATV22 may be symmetrical to each other.

In an embodiment, the second-first semiconductor pattern ATV21 and the second-second semiconductor pattern ATV22 may be physically connected to each other. For example, at least a part of the first part ATV21-P1 of the second-first semiconductor pattern ATV21 may be connected physically connected to at least a part of the first part ATV22-P1 of the second-second semiconductor pattern ATV22.

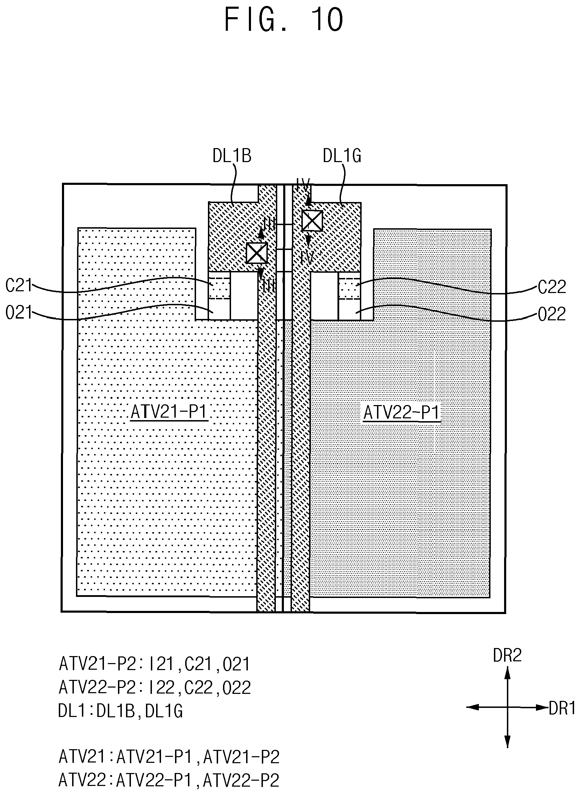

Referring to FIG. 10, the first data line pair DL1 (i.e., DL1B and DL1G) may be disposed on the second-first semiconductor pattern ATV21 and the second-second semiconductor pattern ATV22.

The first sub-data line DL1B may be electrically connected to the second part ATV22-P2 of the second-second semiconductor pattern ATV22. More specifically, the first sub-data line DL1B may be electrically connected to the conductive region I22 of the second-second semiconductor pattern ATV22.

The second sub-data line DL1G may be electrically connected to the second part ATV12-P2 of the second-first semiconductor pattern ATV21. More specifically, the second sub-data line DL1G may be electrically connected to the conductive region I21 of the second-first semiconductor pattern ATV21.

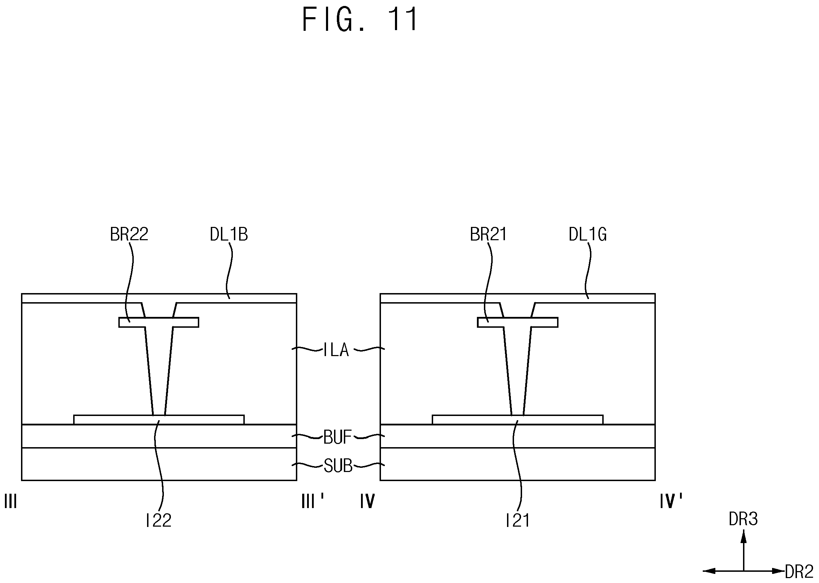

Referring to FIG. 11, the second-first semiconductor pattern ATV21 and the second-second semiconductor pattern ATV22 may be disposed on the buffer layer BUF. For example, as shown in FIG. 11, the conductive region I21 of the second-first semiconductor pattern ATV21 may be disposed on the buffer layer BUF, and the conductive region I22 of the second-second semiconductor pattern ATV22 may be disposed on the buffer layer BUF.

The insulating layer array ILA may be disposed on the buffer layer BUF and may cover the conductive region I21 of the second-first semiconductor pattern ATV21 and the conductive region I22 of the second-second semiconductor pattern ATV22.

The first sub-data line DL1B and the second sub-data line DL1G may be disposed on the insulating layer array ILA. In this case, the first sub-data line DL1B may be disposed to overlap at least a part of the conductive region I22 of the second-second semiconductor pattern ATV22, and the second sub-data line DL1G may overlap at least a part of the conductive region I21 of the second-first semiconductor pattern ATV21.

The first sub-data line DL1B may be electrically connected to the conductive region I22 of the second-second semiconductor pattern ATV22.

For example, as shown in FIG. 11, the first sub-data line DL1B may electrically connect a second-second bridge electrode BR22, and the second-second bridge electrode BR22 may electrically connect the conductive region I22 of the second-second semiconductor pattern ATV22. In this case, the second-second bridge electrode BR11 may be disposed between the first sub-data line DL1B and the second-second semiconductor pattern ATV22 in the circuit layer CIR and the line layer LL.

Unlike in FIG. 11, the first sub-data line DL1B may electrically contact the conductive region I22 of the second-second semiconductor pattern ATV22 through two or more bridge electrodes. In some embodiments, the second-second bridge electrode BR22 may be omitted, and the first sub-data line DL1B may electrically connect to the conductive region I22 of the second-second semiconductor pattern ATV22.

The second sub-data line DL1G may be electrically connected to the conductive region I21 of the second-first semiconductor pattern ATV21.

For example, as shown in FIG. 11, the second sub-data line DL1G may electrically contact a second-first bridge electrode BR21, and the second-first bridge electrode BR21may be electrically contact the conductive region I21 of the second-first semiconductor pattern ATV21. In this case, the second-first bridge electrode BR21 may be disposed between the second sub-data line DL1G and the second-first semiconductor pattern ATV21 in the circuit layer CIR and the line layer LL.

In some embodiments, unlike in FIG. 11, the second sub-data line DL1G may electrically contact the conductive region I21 of the second-first semiconductor pattern ATV21 through two or more bridge electrodes. In some embodiments, the second-first bridge electrode BR21 may be omitted, and the second sub-data line DL1G may electrically contact the conductive region I21 of the second-first semiconductor pattern ATV21.

In FIGS. 8, 9, 10, and 11, only the second-first pixel circuit portion SP21, the second-second pixel circuit portion SP22, the first sub-data line DL1B, and the second sub-data line DL1G are described, the contents described with reference to FIGS. 8, 9, 10, and 11 may be similar applied to the second-third pixel circuit portion SP23, the second-fourth pixel circuit portion SP24, the third sub-data line DL2R, and the fourth sub-data line DL2G. That is, the second-third pixel circuit portion SP23, the second-fourth pixel circuit portion SP24, the third sub-data line DL2R, and the fourth sub-data line DL2G may have substantially the same structure as the second-first pixel circuit portion SP21, the second -second pixel circuit portion SP22, the first sub-data line DL1B, and the second sub-data line DL1G.

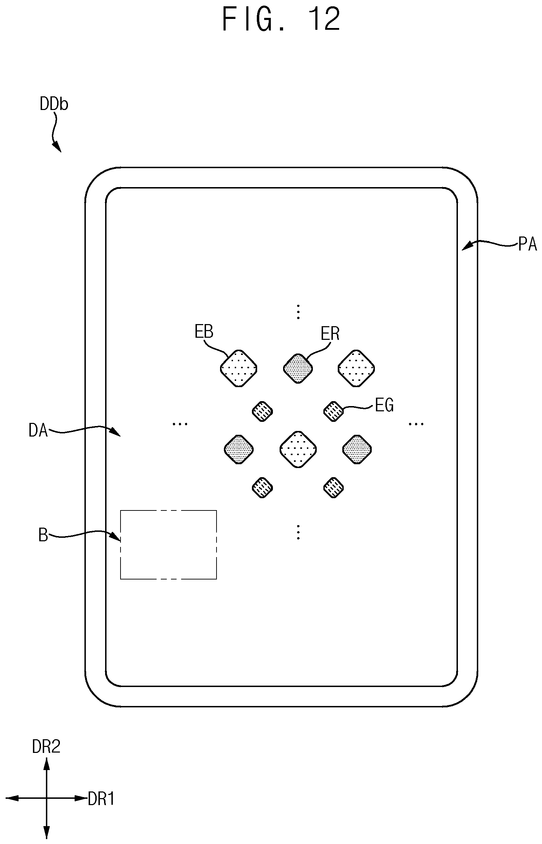

FIG. 12 is a plan view for explaining a display device according to a second embodiment of the present invention.

Referring to FIG. 12, a display device DDb according to the second embodiment of the present invention may include a display area DA and a peripheral area PA, and a first color light emitting portion EB, a second color light emitting portion ER, and a third color light emitting portion EG may be disposed in the display area DA.

In this case, the display device DDb according to the second embodiment of the present invention shown in FIG. 12 may be substantially the same as the display device DDa according to the first embodiment of the present invention described with reference to FIG. 1. Therefore, redundant description of elements will be omitted.

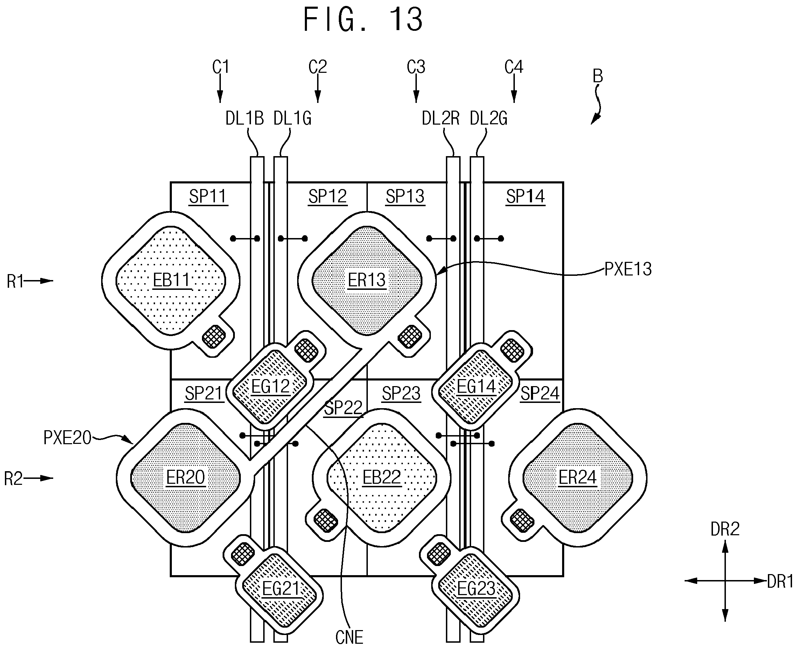

FIG. 13 is an enlarged plan view of area B of FIG. 12.

Referring to FIG. 13, a plurality of pixel circuit portions SP, a first data line pair DL1, a second data line pair DL2, the first color light emitting portion EB, the second color light emitting portion EG, and the third color light emitting portion ER may be disposed in the display area DA.

The plurality of pixel circuit portions SP may be substantially the same as the plurality of pixel circuit portions SP described with reference to FIGS. 2, 3, 4, 5, 6, 7, 8, 9, 10, and 11. Therefore, redundant description of elements will be omitted.

The first data line pair DL1 and the second data line pair DL2 may be substantially the same as the first data line pair DL1 and the second data line pair DL2 described with reference FIGS. 2, 3, 4, 5, 6, 7, 8, 9, 10, and 11. Therefore, redundant description of elements will be omitted.

The first color light emitting portion EB and the second color light emitting portion EG may be substantially the same as the first color light emitting portion EB and the second color light emitting portion EG described with reference to FIGS. 2, 3, 4, 5, 6, 7, 8, 9, 10, and 11. Therefore, redundant description of elements will be omitted.

The third color light emitting portion ER may include a first-third light emitting portion ER13 electrically connected to a first-third pixel circuit portion SP13, a second-fourth light emitting portion ER24 electrically connected to a second-fourth pixel circuit portion SP24, and a second-zeroth light emitting portion ER20 electrically connected to a first-third light emitting portion ER13. In this case, the first-third light emitting portion ER13 and the second-fourth light emitting portion EG24 may be substantially the same. The first-third light emitting portion ER13 and the second-fourth light emitting portion EG24 are described with reference to FIGS. 2, 3, 4, 5, 6, 7, 8, 9, 10, and 11. Redundant description of parts will omitted.

Unlike the display device DDa according to the first embodiment of the present invention shown in FIG. 2, the second-zeroth light emitting portion ER20 in the display device DDb according to the second embodiment of the present invention shown in FIG. 13 is not connected to the second-zeroth dummy pixel circuit portion (DSP20 of FIG. 2). Instead, the second-zeroth light emitting portion ER20 may be electrically connected to the first-third light emitting portion ER13, and accordingly, the second-zeroth light emitting portion ER20 may receive the same light emitting signal as the light emitting signal provided to the first-third light emitting portion ER13.

More specifically, the second-zeroth light emitting portion ER20 may include a second-zeroth pixel electrode PXE20, and the first-third light emitting portion ER13 may include a first-third pixel electrode PXE13. In this case, the first-third pixel electrode PXE13 may be electrically connected to the first-third pixel circuit portion SP13. In addition, the first-third pixel electrode PXE13 may be electrically connected to the second-zeroth pixel electrode PXE20 through a connection electrode CNE. Accordingly, the second-zeroth pixel electrode PXE20 may be electrically connected to the first-third pixel circuit portion SP13through the first-third pixel electrode PXE13.

In an embodiment, the first-third pixel electrode PXE13, the connection electrode CNE, and the second-zeroth pixel electrode PXE20 may be formed integrally.

In an embodiment, the connection electrode CNE may extend diagonally to pass between a first-second light emitting portion EG12 and a second-second light emitting portion EB22. In this case, the connection electrode CNE may be electrically insulated from each of the first-second light emitting portion EG12 and the second-second light emitting portion EB22.

Accordingly, in the display device DDb according to the second embodiment of the present invention, the dummy pixel circuit portion DSP and the dummy data line DL0 included in the display device DDa according to the first embodiment of the present invention may be omitted. In this case, even if the dummy pixel circuit portion DSP and the dummy data line DL0 are omitted, in the display device DDb according to the second embodiment of the present invention, the first color light emitting portion EB, the second color light emitting portion EG, and the third color light emitting portion ER may be disposed in a Pentile^{®} configuration.

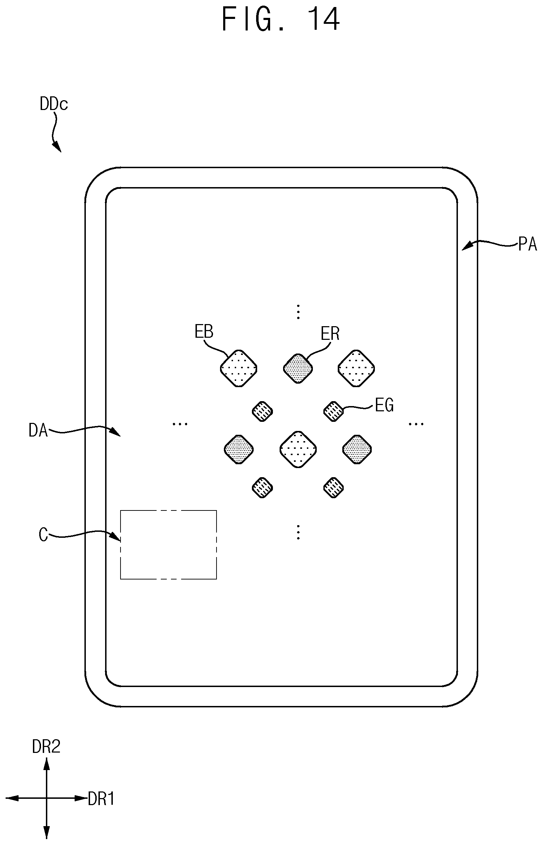

FIG. 14 is a plan view for explaining a display device according to a third embodiment of the present invention.

Referring to FIG. 14, a display device DDc according to the third embodiment of the present invention may include a display area DA and a peripheral area PA, and a first color light emitting portion EB, a second color light emitting portion ER, and a third color light emitting portion EG may be disposed in the display area DA.

The display device DDc according to the third embodiment of the present invention shown in FIG. 14 may be substantially the same as the display device DDa according to the first embodiment of the present invention described with reference to FIG. 1. Any redundant description of elements will be omitted.

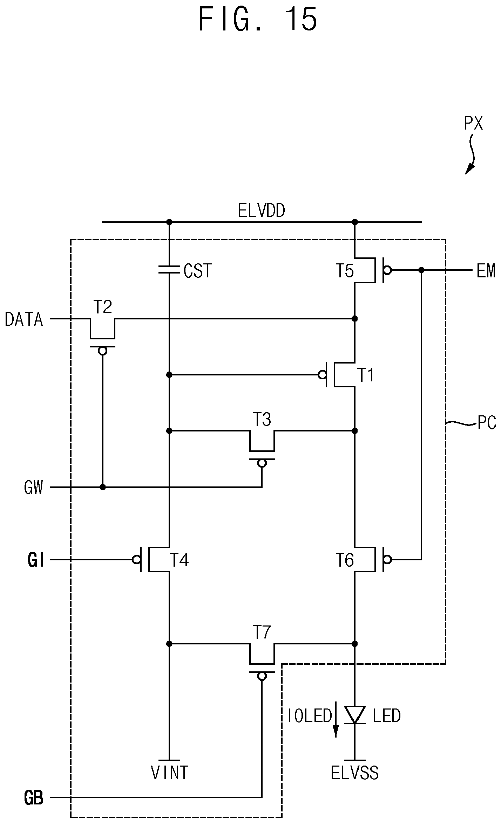

FIG. 15 is an equivalent circuit diagram showing one pixel.

Referring to FIG. 15, the pixel PX may include a pixel circuit portion PC that generates a driving current IOLED and a light emitting element LED electrically connected to the pixel circuit portion PC. Here, the pixel circuit portion PC may include first, second, third, fourth, fifth, sixth, and seventh transistors T1, T2, T3, T4, T5, T6, and T7 and a storage capacitor CST.

The light emitting element LED may output light based on the driving current IOLED. The light emitting element LED may include a first terminal and a second terminal. For example, the second terminal of the light emitting element LED may receive a common voltage ELVSS.

The first transistor T1 may generate driving current IOLED. In an embodiment, the first transistor T1 may be defined as a driving transistor for driving the pixel PX. The first transistor T1 may generate a driving current IOLED based on the voltage difference between the first transistor's gate terminal and source terminal.

The second transistor T2 may include a gate terminal, a first terminal, and a second terminal. The gate terminal of the second transistor T2 may be receive a first scan signal GW. The first terminal of the second transistor T2 may be receive a data voltage DATA. The second terminal of the second transistor T2 may be connected to the first terminal of the first transistor T1.

The third transistor T3 may include a gate terminal, a first terminal, and a second terminal. The gate terminal of the third transistor T3 may receive the first scan signal GW. The first terminal of the third transistor T3 may be connected to the first terminal of the first transistor T1. The second terminal of the third transistor T3 may be connected to the gate terminal of the first transistor T1.

The fourth transistor T4 may include a gate terminal, a first terminal, and a second terminal. The gate terminal of the fourth transistor T4 may receive a data initialization signal GI. The first terminal of the fourth transistor T4 may receive an initialization voltage VINT. The second terminal of the fourth transistor may be connected to the second terminal of the third transistor T3.

The fifth transistor T5 may include a gate terminal, a first terminal, and a second terminal. The gate terminal of the fifth transistor T5 may receive a light emitting control signal EM. The first terminal of the fifth transistor T5 may receive a driving voltage ELVDD. The second terminal of the fifth transistor T5 may be connected to the first terminal of the first transistor T1.

The sixth transistor T6 may include a gate terminal, a first terminal, and a second terminal. The gate terminal of the sixth transistor T6 may receive the light emitting control signal EM. The first terminal of the sixth transistor T6 may be connected to the second terminal of the first transistor T1. The second terminal of the sixth transistor T6 may be connected to the first terminal of the light emitting element LED.

The seventh transistor T7 may include a gate terminal, a first terminal, and a second terminal. The gate terminal of the seventh transistor T7 may receive a second scan signal GB. The first terminal of the seventh transistor T7 may receive the initialization voltage VINT. The second terminal of the seventh transistor T7 may be connected to the first terminal of the light emitting element LED.

The storage capacitor CST may include a first terminal and a second terminal. The first terminal of the storage capacitor CST may receive the driving voltage ELVDD. The second terminal of the storage capacitor CST may be connected to the gate terminal of the first transistor T1.

The pixel circuit portion PC and the light emitting element LED of FIG. 15 correspond to a pixel circuit portion SP' and the color light emitting portions EB, ER, and EG electrically connected to each other of FIGS. 14 and 16, 17, 18, 19, 20, 21, 22, 23, 24, 25, 26, and 27, respectively. That is, an extension line described later is not a component of the pixel circuit portion PC, but may be a line electrically connecting the pixel circuit portion PC and the light emitting element LED.

In addition, the pixel circuit portion PC and the light emitting element LED of FIG. 15 correspond to the pixel circuit portion SP and the color light emitting portions EB, ER, and EG electrically connected to each other of FIGS. 1, 2, 12, and 13, respectively.

However, with reference to FIG. 15, the pixel circuit portion PC has been described as including seven transistors and one storage capacitor, but embodiments of the present invention are not limited thereto. For example, the pixel circuit portion PC may have a component including at least one transistor and at least one storage capacitor.

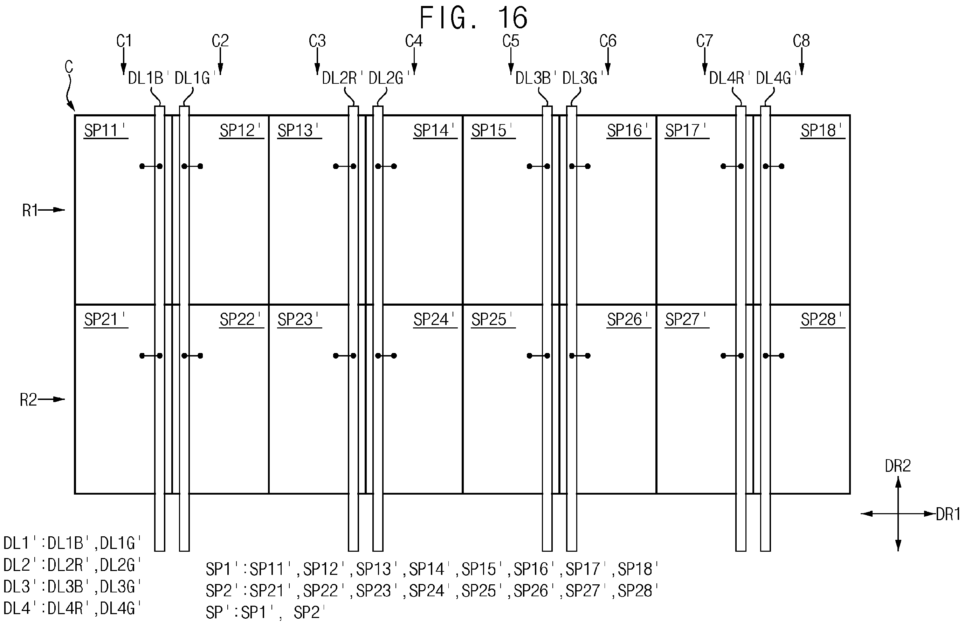

FIG. 16 is a plan view for explaining pixel circuit portions and sub-data lines disposed in area C of FIG. 14. The area C may be part of the display area DA.

Referring to FIG. 16, the plurality of pixel circuit portions SP' may be disposed in the display area DA.

In an embodiment, the plurality of pixel circuit portions SP' may be disposed in a matrix configuration. For example, the plurality of pixel circuit portions SP' may include a first-first pixel circuit portion SP11', a first-second pixel circuit portion SP12', a first-third pixel circuit portion SP13', a first-fourth pixel circuit portion SP14', a first-fifth pixel circuit portion SP15', a first-sixth pixel circuit portion SP16', a first-seventh pixel circuit portion SP17', a first-eighth pixel circuit portion SP18', a second-first pixel circuit portion SP21', a second-second pixel circuit portion SP22', a second-third pixel circuit portion SP23', a second-fourth pixel circuit portion SP24', a second-fifth pixel circuit portion SP25', a second-sixth pixel circuit portion SP26', a second-seventh pixel circuit portion SP27', and a second-eighth pixel circuit portion SP28' in rows and eight columns.

The first-first pixel circuit portion SP11', the first-second pixel circuit portion SP12', the first-third pixel circuit portion SP13', the first-fourth pixel circuit portion SP14', the first-fifth pixel circuit portion SP15', the first-sixth pixel circuit portion SP16', the first-seventh pixel circuit portion SP17', the first-eighth pixel circuit portion SP18' may be arranged in a logical order in the row direction DR1 along a first pixel row R1. In this case, the first-first pixel circuit portion SP11', the first-second pixel circuit portion SP12', the first-third pixel circuit portion SP13', the first-fourth pixel circuit portion SP14', the first-fifth pixel circuit portion SP15', the first-sixth pixel circuit portion SP16', the first-seventh pixel circuit portion SP17', the first-eighth pixel circuit portion SP18' may be referred to as first pixel circuit portions SP1'.

The second-first pixel circuit portion SP21', the second-second pixel circuit portion SP22', the second-third pixel circuit portion SP23', the second-fourth pixel circuit portion SP24', the second-fifth pixel circuit portion SP25', the second-sixth pixel circuit portion SP26', the second-seventh pixel circuit portion SP27', and the second-eighth pixel circuit portion SP28' may be arranged in a logical order in the row direction DR1 along a second pixel row R2 adjacent to the first pixel row R1 in the column direction DR2. In this case, the second-first pixel circuit portion SP21', the second-second pixel circuit portion SP22', the second-third pixel circuit portion SP23', the second-fourth pixel circuit portion SP24', the second-fifth pixel circuit portion SP25', the second-sixth pixel circuit portion SP26', the second-seventh pixel circuit portion SP27', and the second-eighth pixel circuit portion SP28' may be referred to as second pixel circuit portions SP2'.

The first-first pixel circuit portion SP11' and the second-first pixel circuit part SP21' may be disposed in a first pixel column C1. The first-first pixel circuit portion SP11' and the second-first pixel circuit part SP21' may be arranged in a logical order in the column direction DR2.

The first-second pixel circuit portion SP12' and the second-second pixel circuit portion SP22' may be disposed in a second pixel column C2. The second pixel column C2 may be adjacent to the first pixel column C1 in the row direction DR1. The first-second pixel circuit portion SP12' and the second-second pixel circuit portion SP22' may be arranged in a logical order in the column direction DR2.

The first-third pixel circuit portion SP13' and the second-third pixel circuit portion SP23' may be disposed in a third pixel column C3. The third pixel column C3 may be adjacent to the second pixel column C2 in the row direction DR1. The first-third pixel circuit portion SP13' and the second-third pixel circuit portion SP23' may be arranged in a logical order in the column direction DR2.

The first-fourth pixel circuit portion SP14' and the second-fourth pixel circuit portion SP24' may be disposed in a fourth pixel column C4. The fourth pixel column C4 may be adjacent to the third pixel column C3 in the row direction DR1. The first-fourth pixel circuit portion SP14' and the second-fourth pixel circuit portion SP24' may be arranged in a logical order in the column direction DR2.

The first-fifth pixel circuit portion SP15' and the second-fifth pixel circuit portion SP25' may be disposed in a fifth pixel column C5. The fifth pixel column C5 may be adjacent to the fourth pixel column C4 in the row direction DR1. The first-fifth pixel circuit portion SP15' and the second-fifth pixel circuit portion SP25' may be arranged in a logical order in the column direction DR2.

The first-sixth pixel circuit portion SP16' and the second-sixth pixel circuit portion SP26' may be disposed in a sixth pixel column C6. The sixth pixel column C6 may be adjacent to the fifth pixel column C5 in the row direction DR1. The first-sixth pixel circuit portion SP16' and the second-sixth pixel circuit portion SP26' may be arranged in a logical order in the column direction DR2.

The first-seventh pixel circuit portion SP17' and the second-seventh pixel circuit portion SP27' may be disposed in a seventh pixel column C7. The seventh pixel column C7 may be adjacent to the sixth pixel column C6 in the row direction DR1. The first-seventh pixel circuit portion SP17' and the second-seventh pixel circuit portion SP27' may be arranged in a logical order in the column direction DR2.

The first-eighth pixel circuit portion SP18' and the second-eighth pixel circuit portion SP28' may be disposed in an eighth pixel column C8. The eighth pixel column C8 may be adjacent to the seventh pixel column C7 in the row direction DR1. The first-eighth pixel circuit portion SP18' and the second-eighth pixel circuit portion SP28' may be arranged in a logical order in the column direction DR2.

A first data line pair DL1', a second data line pair DL2', a third data line pair DL3', and a fourth data line pair DL4' may be disposed on the plurality of pixel circuit portions SP'.

The first data line pair DL1' may include a first sub-data line DL1B' and a second sub-data line DL1G'. The second data line pair DL2' may include a third sub-data line DL2R' and a fourth sub-data line DL2G'. The third data line pair DL3' may include a fifth sub-data line DL3B' and a sixth sub-data line DL3G'. The fourth data line pair DL4' may include a seventh sub-data line DL4R' and an eighth sub-data line DL4G'.

The first sub-data line DL1B' may be disposed in the first pixel column C1. In the embodiment of FIG. 16, the first sub-data line DL1B' is disposed on a part of the first column C1 that is close to the second column C2. The first sub-data line DL1B' may be disposed on the first-first pixel circuit portion SP11' and the second-first pixel circuit portion SP21' in a plan view. The first sub-data line DL1B' may extend in the column direction DR2.

The second sub-data line DL1G' may be disposed in the second pixel column C2. In the embodiment of FIG. 16, the second sub-data line DL1G' is disposed on a part of the second column C2 that is close to the first column C1. The second sub-data line DL 1 G' may be disposed on the first-second pixel circuit portion SP12' and the second-second pixel circuit portion SP22' in the plan view. The second sub-data line DL1G' may extend in the column direction DR2.

The third sub-data line DL2R' may be disposed in the third pixel column C3. In the embodiment of FIG. 16, the third sub-data line DL2R' is disposed on a part of the third column C3 that is far from the second column C2. That is, the third sub data line DL2R' may be disposed on the first-third pixel circuit portion SP13' and the second-third pixel circuit portion SP23' in the plan view. The third sub-data line DL2R' may extend in the column direction DR2.

The fourth sub-data line DL2G' may be disposed in the fourth pixel column C4. In the embodiment of FIG. 16, the fourth sub-data line DL2G' is disposed on a part of the fourth column C4 that is close to the third column C3. The fourth sub-data line DL2G' may be disposed on the first-fourth pixel circuit portion SP14' and the second-fourth pixel circuit portion SP24' in the plan view. The fourth sub-data line DL2G' may extend in the column direction DR2.

The fifth sub-data line DL3B' may be disposed in the fifth pixel column C5. In the embodiment of FIG. 16, the fifth sub-data line DL3B' is disposed on a part of the fifth column C5 that is far from the fourth column C4. The fifth sub-data line DL3B' may be disposed on the first-fifth pixel circuit portion SP15' and the second-fifth pixel circuit part SP25' in the plan view. The fifth sub-data line DL3B' may extend in the column direction DR2.

The sixth sub-data line DL3G' may be disposed in the sixth pixel column C6. In the embodiment of FIG. 16, the sixth sub-data line DL3G' is disposed on a part of the sixth column C6 that is close to the fifth column C5. The sixth sub-data line DL3G' may be disposed on the first-sixth pixel circuit portion SP16' and the second-sixth pixel circuit portion SP26' in the plan view. The sixth sub-data line DL3G' may extend in the column direction DR2.

The seventh sub-data line DL4R' may be disposed in the seventh pixel column C7. In the embodiment of FIG. 16, the seventh sub-data line DL4R' is disposed on a part of the seventh column C7 that is far from the sixth column C6. The seventh sub-data line DL4R' may be disposed on the first-seventh pixel circuit portion SP17' and the second-seventh pixel circuit portion SP27' in the plan view. The seventh sub-data line DL4R' may extend in the column direction DR2.

The eighth sub-data line DL4G' may be disposed in the eighth pixel column C8. In the embodiment of FIG. 16, the eighth sub-data line DL4G' is disposed on a part of the eighth column C8 that is close to the seventh column C7. The eighth sub-data line DL4G' may be disposed on the first-eighth pixel circuit portion SP18' and the second-eighth pixel circuit portion SP28' in the plan view. The eighth sub-data line DL4G' may extend in the column direction DR2.

The first sub-data line DL1B' may be electrically connected to each of the first-first pixel circuit portion SP11' and the second-first pixel circuit portion SP21'. In an embodiment, a first color data voltage corresponding to the first color may be provided to the first sub-data line DL1B'.

The second sub-data line DL1G' may be electrically connected to each of the first-second pixel circuit portion SP12' and the second-second pixel circuit portion SP22'. In an embodiment, a second color data voltage corresponding to the second color may be provided to the second sub-data line DL1G'.

The third sub-data line DL2R' may be electrically connected to each of the first-third pixel circuit portion SP13' and the second-third pixel circuit portion SP23'. In an embodiment, a third color data voltage corresponding to the third color may be provided to the third sub-data line DL2R'.

The fourth sub-data line DL2G' may be electrically connected to each of the first-fourth pixel circuit portion SP14' and the second-fourth pixel circuit portion SP24'. In an embodiment, a second color data voltage corresponding to the second color may be provided to the fourth sub-data line DL2G' .

The fifth sub-data line DL3B' may be electrically connected to each of the first-fifth pixel circuit portion SP15' and the second-fifth pixel circuit portion SP25'. In an embodiment, a first color data voltage corresponding to the first color may be provided to the fifth sub-data line DL3B' .

The sixth sub-data line DL3G' may be electrically connected to each of the first-sixth pixel circuit portion SP16' and the second-sixth pixel circuit portion SP26'. In an embodiment, a second color data voltage corresponding to the second color may be provided to the sixth sub-data line DL3G'.

The seventh sub-data line DL4R' may be electrically connected to each of the first-seventh pixel circuit portion SP17' and the second-seventh pixel circuit portion SP27'. In an embodiment, a third color data voltage corresponding to the third color may be provided to the seventh sub-data line DL4R'.

The eighth sub-data line DL4G' may be electrically connected to each of the first-eighth pixel circuit portion SP18' and the second-eighth pixel circuit portion SP28'. In an embodiment, a second color data voltage corresponding to the second color may be provided to the eighth sub-data line DL4G' .

The first-first pixel circuit portion SP11', the first-second pixel circuit portion SP12', the first sub-data line DL1B', and the second sub-data line DL1G' shown in FIG. 16 may be substantially the same as the first-first pixel circuit portion SP11, the first-second pixel circuit portion SP12, the first sub-data line DL1B, and the second sub-data line DL1G, which were described with reference to FIGS. 4, 5, 6, and 7.

In this case, the second-first pixel circuit portion SP21', the second-second pixel circuit portion SP22', the first sub-data line DL1B' electrically connected to the second-first pixel circuit portion SP21', and the second sub-data line DL1G' electrically connected to the second-second pixel circuit portion SP22' may have substantially the same structure as the first-first pixel circuit portion SP11', the first-second pixel circuit portion SP12', the first sub-data line DL1B' electrically connected to the first-first pixel circuit portion SP11', and the second sub-data line DL1G' electrically connected to the first-second pixel circuit portion SP12.

The structure of the first-first pixel circuit portion SP 11', the first-second pixel circuit portion SP12', the second-first pixel circuit portion SP21', the second-second pixel circuit portion SP22', the first sub-data line DL1B', and the second sub-data line DL1G' may also be applied to the first-third pixel circuit portion SP13', the first-fourth pixel circuit portion SP14', the second-third pixel circuit portion SP23', the second-fourth pixel circuit portion SP24', the third sub-data line DL2R, and the fourth sub-data line DL2G'.

Similarly, the first-fifth pixel circuit portion SP15', the first-sixth pixel circuit portion SP 16', the first-seventh pixel circuit portion SP17', the first-eighth pixel circuit portion SP 18', the second-fifth pixel circuit portion SP25', the second-sixth pixel circuit portion SP26', the second-seventh pixel circuit portion SP27', the second-eighth pixel circuit portion SP28', the fifth sub-data line DL3B', the sixth sub-data line DL3G', the seventh sub-data line DL4R', and the eighth sub-data line DL4G' may have substantially the same structure as the first-first pixel circuit portion SP11', the first-second pixel circuit portion SP12', the second-first pixel circuit portion SP21', the second-second pixel circuit portion SP22', the first sub-data line DL1B', and the second sub-data line DL1G'.

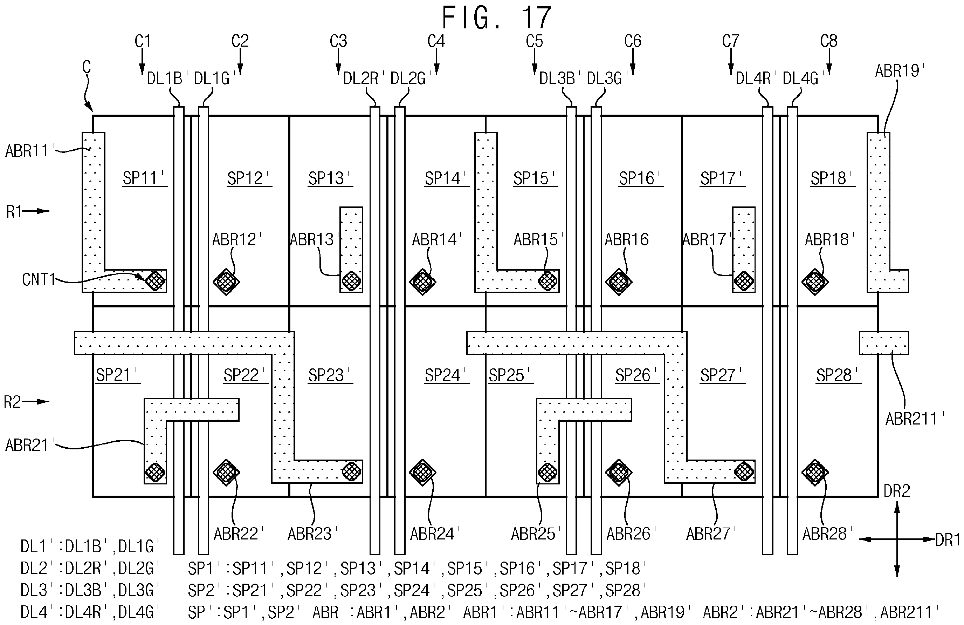

FIG. 17 is a plan view for explaining extension lines disposed in area C of FIG. 14.

Referring to FIG. 17, a plurality of extension lines ABR' may be disposed on the plurality of pixel circuit portions SP', the first data line pair DL1', the second data line pair DL2', the third data line pair DL3', and the fourth data line pair DL4'.

The plurality of extension lines ABR' may include a plurality of first extension lines ABR1' electrically connected one-to-one with the plurality of first pixel circuit portions SP1' and a plurality of second extension lines ABR2' electrically connected one-to-one with the plurality of second pixel circuit portions SP2'.

The plurality of first extension lines ABR1' may include a first-first extension line ABR11', a first-second extension line ABR12 , a first-third extension line ABR13', a first-fourth extension line ABR14 , a first-fifth extension line ABR15', a first-sixth extension line ABR16', a first-seventh extension line ABR17', a first-eighth extension line ABR18', and a first-ninth extension line ABR19'.

The first-first extension line ABR11' may be electrically connected to the first-first pixel circuit portion SP11'. For example, the first-first extension line ABR11' may be electrically connected to the first-first pixel circuit portion SP11' through a first contact hole CNT1.

Likewise, the first-second extension line ABR12' may be electrically connected to the first-second pixel circuit portion SP12', the first-third extension line ABR13' may be electrically connected to the first-third pixel circuit portion SP13', the first-fourth extension line ABR14' may be electrically connected to the first-fourth pixel circuit portion SP14', the first-fifth extension line ABR15' may be electrically connected to the first-fifth pixel circuit portion SP15', the first-sixth extension line ABR16' may be electrically connected to the first-sixth pixel circuit portion SP16', the first-seventh extension line ABR17' may be electrically connected to the first-seventh pixel circuit portion SP17', and the first-eighth extension line ABR18' may be electrically connected to the first-eighth pixel circuit portion SP18'.

In this case, the first-ninth extension line ABR19' may be electrically connected to a first-ninth pixel circuit portion disposed in a ninth pixel column and the first pixel row R1, not shown. In addition, the first-ninth extension line ABR19' may have substantially the same planar shape as the first-fifth extension line ABR15' .

The plurality of second extension lines ABR2' may include a second-first extension line ABR21', a second-second extension line ABR22', a second-third extension line ABR23', a second-fourth extension line ABR24', a second-fifth extension line ABR25', a second-sixth extension line ABR26', a second-seventh extension line ABR27', a second-eighth extension line ABR28', and a second-eleventh extension line ABR211'.

The second-first extension line ABR21' may be electrically connected to the second-first pixel circuit portion SP21', the second-second extension line ABR22' may be electrically connected to the second-second pixel circuit portion SP22', the second-third extension line ABR23' may be electrically connected to the second-third pixel circuit portion SP23', the second-fourth extension line ABR24' may be electrically connected to the second-fourth pixel circuit portion SP24', the second-fifth extension line ABR25' may be electrically connected to the second-fifth pixel circuit portion SP25', the second-sixth extension line ABR26' may be electrically connected to the second-sixth pixel circuit portion SP26', the second-seventh extension line ABR27' may be electrically connected to the second-seventh pixel circuit portion SP27', and the second-eighth extension line ABR28' may be electrically connected to the second-eighth pixel circuit portion SP28'.

In this case, the second-eleventh extension line ABR211' may be electrically connected to a second-eleventh pixel circuit portion disposed in an eleventh pixel column and the second pixel row R2, not shown. In addition, the second-eleventh extension line ABR211' may have substantially the same planar shape as the second-eleventh extension line ABR27' .

In an embodiment, as shown in FIG. 17, the second-first extension line ABR21' may overlap each of the first sub-data line DL1B' and the second sub-data line DL1G' in the plan view, the second-third extension line ABR23' may overlap each of the first sub-data line DL1B') and the second sub-data line DL1G' in the plan view, the second-fifth extension line ABR25' may overlap each of the fifth sub-data line DL3B' and the fourth sub-data line DL3G' in the plan view, and the second-seventh extension line ABR27' may overlap each of the fifth sub-data line DL3B' and the fourth sub-data line DL3G' in the plan view.

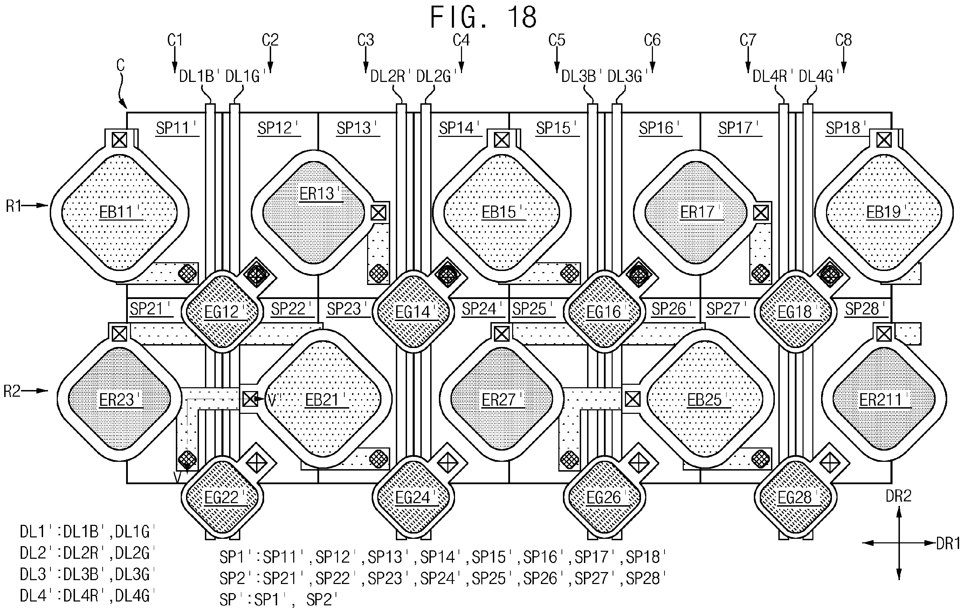

FIG. 18 is an enlarged plan view of area C of FIG. 14.

Referring to FIGS. 17 and 18, the first color light emitting portion EB, the second color emitting portion EG, and the third color emitting portion ER may be disposed on the plurality of extension lines ABR'.

The first color emitting portion EB may include a first-first emitting portion EB 11', a first-fifth emitting portion EB 15', a first-ninth emitting portion EB 19', a second-first emitting portion EB21', and a second-fifth light emitting portion EB25'.

The first-first emitting portion EB11' may be electrically connected to the first-first extension line ABR1'. For example, the first-first light emitting portion EB11' may include a pixel electrode PXE', and the pixel electrode PXE' may be connected to the first-first extension line ABR1' through a second contact hole CNT2.

Likewise, the first-fifth emitting portion EB15' may be electrically connected to the first-fifth extension line ABR15', the first-ninth emitting portion EB19' may be electrically connected to the first-ninth extension line ABR19', the second-first emitting portion EB21' may be electrically connected to the second-first extension line ABR21', and the second-fifth light emitting portion EB25' may be electrically connected to the second-fifth extension line ABR25'.

The second color light emitting portion EG may include a first-second light emitting portion EG12', a first-fourth light emitting portion EG14', a first-sixth light emitting portion EG16', a first-eighth emitting portion EG18', a second-second light emitting portion EG22', a second-fourth light emitting portion EG24', a second-sixth light emitting portion EG26', and a second-eighth light emitting portion EG28'.

The first-second light emitting portion EG12' may be electrically connected to the first-second extension line ABR12 , the first-fourth light emitting portion EG14' may be electrically connected to the first-fourth extension line ABR14 , the first-sixth light emitting portion EG16' may be electrically connected to the first-sixth extension line ABR16', the first-eighth light emitting portion EG18' may be electrically connected to the first-eighth extension line ABR18', the second-second light emitting portion EG22' may be electrically connected to the second-second extension line ABR22', the second-fourth light emitting portion EG24' may be electrically connected to the second-fourth extension line ABR24', the second-sixth light emitting portion EG26' may be electrically connected to the second-sixth extension line ABR26', and the second-eighth light emitting portion EG28' may be electrically connected to the second-eighth extension line ABR28'.

The third color emitting portion ER may include a first-third emitting portion ER13', a first-seventh emitting portion ER17', a second-third emitting portion ER23', a second-seventh emitting portion ER27', and a second-eleventh light emitting portion ER211'.

The first-third emitting portion ER13' may be electrically connected to the first-third extension line ABR13', the first-seventh emitting portion ER17' may be electrically connected to the first-seventh extension line ABR17', the second-third emitting portion ER23' may be electrically connected to the second-third extension line ABR23', the second-seventh emitting portion ER27' may be electrically connected to the second-seventh extension line ABR27', and the second-eleventh emitting portion ER211' may be electrically connected to the second-eleventh extension line ABR211'.

As shown in FIG. 18, the first color light emitting portion EB, the second color light emitting portion EG, and the third color light emitting portion ER may be disposed in a Pentile^{®} configuration.

That is, in the display device DDc according to the third embodiment of the present invention, the plurality of pixel circuit portions SP' may be disposed in a matrix form, but the first color light emitting portion EB, the second color light emitting portion EG, and the third color light emitting portion ER, which are electrically connected to the plurality of pixel circuit portions SP', may be disposed in a Pentile^{®} configuration.

The display device DDc according to the third embodiment of the present invention may include the plurality of extension lines ABR'. In this case, at least one extension line among the plurality of extension lines ABR' may extend in the row direction DR1 and/or the column direction DR2, and one light emitting portion (e.g., EB11') may be electrically connected to a corresponding pixel circuit portion SP11' through one extension line (e.g., ABR11'). Accordingly, the plurality of pixel circuit portions SP' disposed in a matrix configuration may be electrically connected to the first color light emitting portion EB, the second color light emitting portion EG, and the third color light emitting portion ER disposed in a Pentile^{®} configuration.

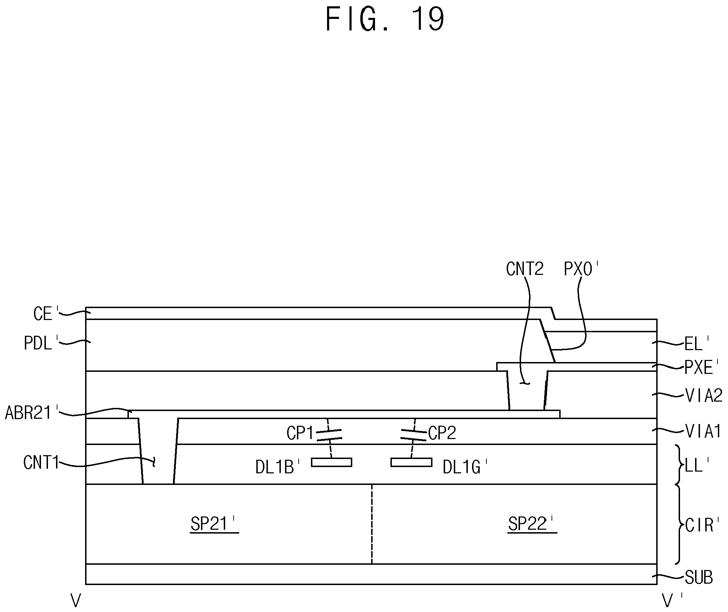

FIG. 19 is a cross-sectional view taken along line V-V' of FIG. 18.

Referring to FIG. 19, the display device DDc according to the third embodiment of the present invention may include a substrate SUB, a circuit layer CIR', a line layer LL', a via insulating layer VIA1, the second-first extension line ABR21', a second via insulating layer VIA2, a pixel electrode PXE', a pixel defining layer PDL', a light emitting layer EL', and a common electrode layer CE'.

The substrate SUB may include glass, plastic, or the like. In an embodiment, the substrate SUB may include a flexible material.

The circuit layer CIR' may be disposed on the substrate SUB. The circuit layer CIR' may include at least one transistor and may include a plurality of pixel circuit units SP'. For example, as shown in FIG. 19, the circuit layer CIR' may include the second-first pixel circuit portion SP21' and the second-second pixel circuit portion SP22' .

The line layer LL' may be disposed on the circuit layer CIR'. The line layer LL' may include at least a data line. For example, as shown in FIG. 19, the line layer LL' may include the first sub-data line DL1B' and the second sub-data line DL1G'. In addition, although not shown in FIG. 19, the line layer LL' may include the second data line pair DL2', the third data line pair DL3', and the fourth data line pair DL4'.

The first via insulating layer VIA1 may be disposed on the line layer LL'. The first via insulating layer VIA1 may include an organic insulating material and/or an inorganic insulating material. The upper surface of the first via insulating layer VIA1 may be substantially flat.

The plurality of extension lines ABR' may be disposed on the first via insulating layer VIA1. For example, as shown in FIG. 19, the second-first extension line ABR21' may be disposed on the first via insulating layer VIA1. In this case, the second-first extension line ABR21' may be electrically connected to the second-first pixel circuit portion SP21' through a first through hole CNT1 penetrating at least the first via insulating layer VIA1 and the line layer LL'.

The second via insulating layer VIA2 may be disposed on the first via insulating layer VIA1. The second via insulating layer VIA2 may include an organic insulating material and/or an inorganic insulating material. The upper surface of the second via insulating layer VIA2 may be substantially flat.

The pixel electrode PXE' may be disposed on the second via insulating layer VIA2. The pixel electrode PXE' may include a conductive material. The pixel electrode PXE' may be electrically connected to the second-first extension line ABR21' through a second through hole CNT2 penetrating the second via insulating layer VIA2. In an embodiment, the pixel electrode PXE' may be an anode electrode.

The pixel defining layer PDL' may be disposed on the second via insulating layer VIA2 and the pixel electrode PXE'. The pixel defining layer PDL' may define a pixel opening PXO' exposing at least a part of the pixel electrode PXE'. The pixel defining layer PDL' may include an organic insulating material and/or an inorganic insulating material.

The light emitting layer EL' may be disposed on the part of the pixel electrode PXE' exposed by the pixel opening PXO'. In an embodiment, the light emitting layer EL' may include an organic light emitting material.

The common electrode layer CE' may be disposed on the light emitting layer EL'. The common electrode layer CE' may include a conductive material. In an embodiment, the common electrode layer CE' may be a cathode electrode.

The pixel electrode PXE', the light emitting layer EL', and the common electrode layer CE' may define the second-first light emitting portion EB21' .

Referring again to FIGS. 17 and 19, the second-first extension line ABR21' may overlap each of the first sub-data line DL1B' and the second sub-data line DL1G' in the plan view. Accordingly, a coupling CP1 may occur between the second-first extension line ABR21' and the first sub-data line DL1B', and a coupling CP2 may occur between the second-first extension line ABR21' and the second sub-data line DL1G'. That is, in an area where the extension line (e.g., ABR21') and the sub-data line (e.g., DL1B' or DL1G') overlap in the plan view, the sub-data line may be affected by coupling (e.g., CP1 or CP2).

In this case, as shown in FIG. 17, the first data line pair DL1' may overlap the two extension lines ABR21' and ABR23' in the plan view, and the third data line pair DL3' may overlap the two extension lines ABR25' and ABR27' .

In contrast, each of the second data line pair DL2' and the fourth data line pair DL4' may not overlap the plurality of extension lines SP' in the plan view.

Accordingly, each of the first data line pair DL1' and the third data line pair DL3' may be affected by coupling due to overlap with the plurality of extension lines SP', and each of the second data line pair DL2' and the fourth data line pair DL4' may not be affected by coupling. As such, when each data line pair has different coupling characteristics, the display quality of the display device DDc may deteriorate.

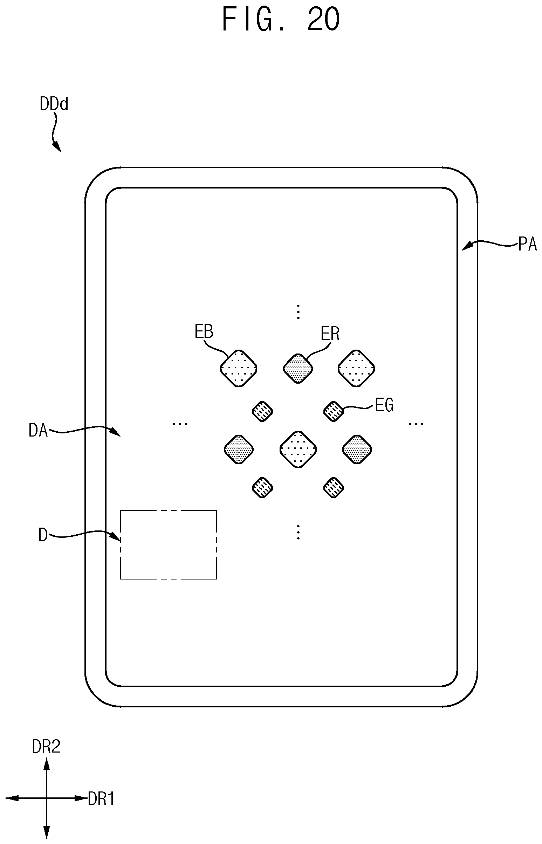

FIG. 20 is a plan view for explaining a display device according to a fourth embodiment of the present invention.

Referring to FIG. 20, a display device DDd according to the fourth embodiment of the present invention may include a display area DA and a peripheral area PA, and a first color light emitting portion EB, a second color light emitting portion ER, and a third color light emitting portion EG may be disposed in the display area DA.

In this case, the display device DDd according to the fourth embodiment of the present invention shown in FIG. 20 may be substantially the same as the display device DDa according to the first embodiment of the present invention described with reference to FIG. 1. there is. Therefore, redundant description of elements will be omitted.

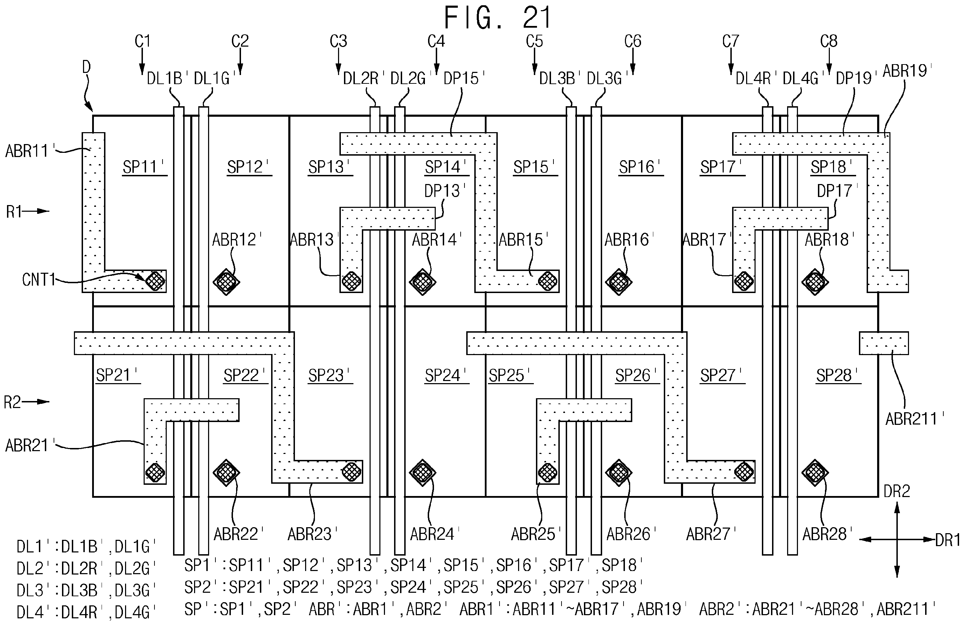

FIGS. 21, 22, 23, 24, 25, 26, and 27 are plan views for explaining various embodiments of extension lines disposed in area D of FIG. 20. The area D may be part of the display area DA.

Referring to FIGS. 21, 22, 23, 24, 25, 26, and 27, substantially the same components as all of the components described with reference to FIGS. 16, 17, and 18 may be disposed in the area D. Accordingly, description of elements that were already described above, for example in reference to FIGS. 16, 17, and 18, will be omitted.

In this case, unlike the plurality of extension lines ABR' described with reference to FIG. 17, a plurality of extension lines ABR' shown in each of FIGS. 21, 22, 23, 24, 25, 26, and 27 may include additional components to prevent different coupling characteristics for each data line pair. Therefore, hereinafter, the plurality of extension lines ABR' shown in FIGS. 21, 22, 23, 24, 25, 26, and 27 will be described, focusing on differences from the content described with reference to FIG. 17.

Referring to FIG. 21, FIG. 21 is a plan view showing the plurality of extension lines ABR' according to the first embodiment.

In this case, unlike the plurality of extension liens ABR' described with reference to FIG. 17, a first-third extension line ABR13' may further include a dummy part DP13 , a first-fifth extension line ABR15' may further include a dummy part DP15', a first-seventh extension line ABR17' may further include a dummy part DP17', and a first-ninth extension line ABR19' may further include a dummy part DP 19'.

In this case, the dummy part DP13' may be formed integrally with the first-third extension line ABR13' described with reference to FIG. 17, the dummy part DP15' may be formed integrally with the first-fifth extension line ABR15' described with reference to FIG. 17, the dummy part DP 17' may be formed integrally with the first-seventh extension line ABR17' described with reference to FIG. 17, and the dummy part DP19' may be formed integrally with the first-ninth extension line ABR19' described with reference to FIG. 17.

The dummy part DP13' of the first-third extension line ABR13' may overlap a second data line pair DL2' in the plan view, the dummy part DP 15 of the first-fifth extension line ABR15' may overlap the second data line pair DL2' in the plan view, the dummy part DP17' of the first-seventh extension line ABR17' may overlap a fourth data line pair DL4' in the plan view, and the dummy part DP19 of the first-ninth extension line ABR19' may overlap the fourth data line pair DL4' in the plan view.

Accordingly, each of a first data line pair DL1', the second data line pair DL2', a third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

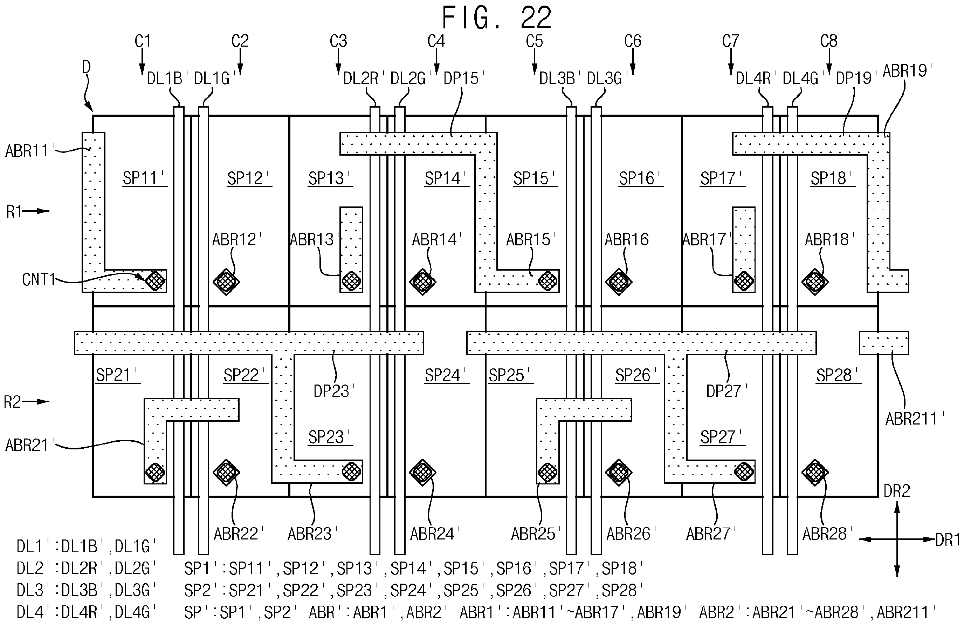

Referring to FIG. 22, FIG. 22 is a plan view showing a plurality of extension lines ABR' according to the second embodiment.

In this case, unlike the plurality of extension lines ABR' described with reference to FIG. 17, a first-fifth extension line ABR15' may further include a dummy part DP15 , a first-ninth extension line ABR19' may further include a dummy part DP19', a second-third extension line ABR23' may further include a dummy part DP23', and a second-seventh extension line ABR27' may further include a dummy part DP27' .

In this case, the dummy part DP15' may be formed integrally with the first-fifth extension line ABR15' described with reference to FIG. 17, the dummy part DP19' may be formed integrally with the first-ninth extension line ABR19' described with reference to FIG. 17, the dummy part DP23' may be formed integrally with the second-third extension line ABR23' described with reference to FIG. 17, and the dummy part DP27' may be formed integrally with the second-seventh extension line ABR27' described with reference to FIG. 17.

The dummy part DP15' of the first-fifth extension line ABR15' may overlap a second data line pair DL2' in the plan view, the dummy part DP 19' of the first-ninth extension line ABR19' may overlap a fourth data line pair DL4' in the plan view, the dummy part DP23' of the second-third extension line ABR23' may overlap the second data line pair DL2' in the plan view, and the dummy part DP27' of the second-seventh extension line ABR27' may overlap the fourth data line pair DL4' in the plan view.

Accordingly, each of a first data line pair DL1', the second data line pair DL2', a third data line pair DL3', and the fourth data line pair DL4' may overlap the same number of extension line ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

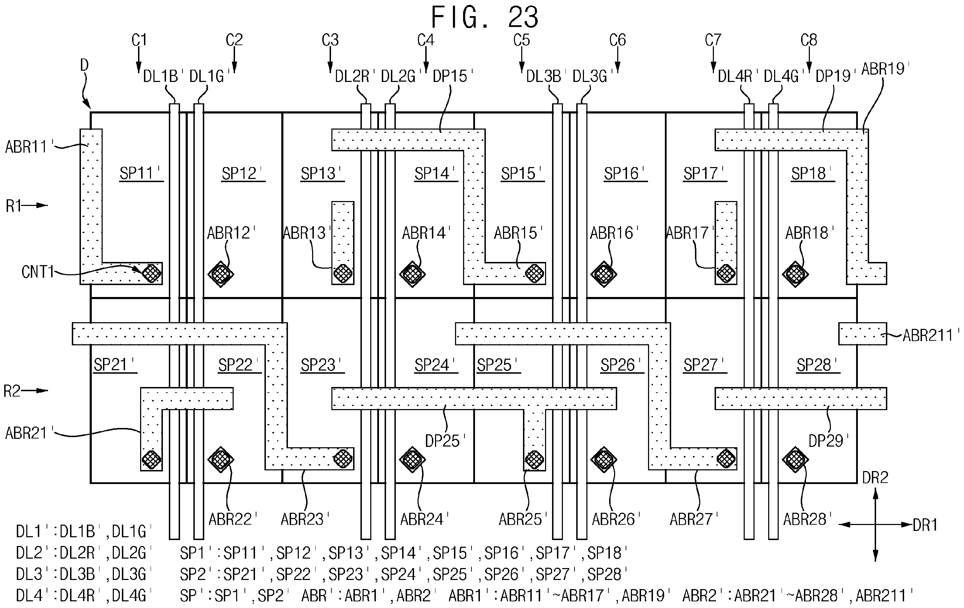

Referring to FIG. 23, FIG. 23 is a plan view showing a plurality of extension lines ABR' according to the third embodiment.

In this case, unlike the plurality of extension lines ABR' described with reference to FIG. 17, a first-fifth extension line ABR15' may further include a dummy part DP15 , a first-ninth extension line ABR19' may further include a dummy part DP19 , and a second-fifth extension line ABR25' may further include a dummy part DP25'. In addition, a second-ninth extension line, not shown in FIG. 17, may further include a dummy part DP29'. The second-ninth extension line may be electrically connected to a second-ninth pixel circuit portion disposed in a ninth pixel column and the second pixel row R2, not shown. In addition, the second-ninth extension line may have substantially the same planar shape as the second-fifth extension line ABR25' .

In this case, the dummy part DP15' may be formed integrally with the first-fifth extension line ABR15' described with reference to FIG. 17, the dummy part DP19' may be formed integrally with the first-ninth extension line ABR19' described with reference to FIG. 17, and the dummy part DP25' may be formed integrally with the second-fifth extension line ABR25' described with reference to FIG. 17.

The dummy part DP15' of the first-fifth extension line ABR15' may overlap a second data line pair DL2' in the plan view, the dummy part DP19 of the first-ninth extension line ABR19' may overlap a fourth data line pair DL4' in the plan view, the dummy part DP25' of the second-fifth extension line ABR25' may overlap the second data line pair DL2' in the plan view, and the dummy part DP29' of the second-ninth extension line may overlap the fourth data line pair DL4' in the plan view.

Accordingly, each of a first data line pair DL1', the second data line pair DL2', a third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

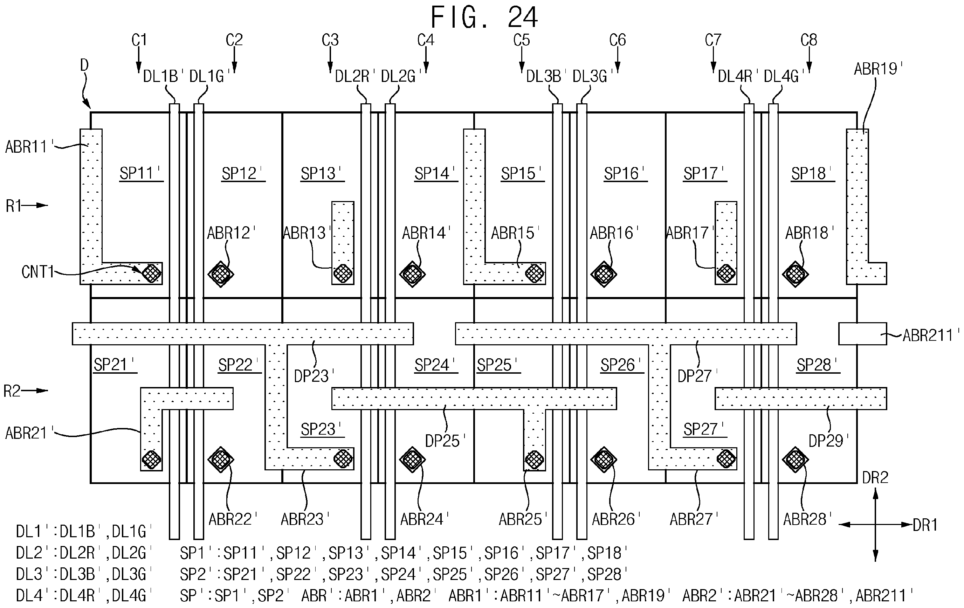

Referring to FIG. 24, FIG. 24 is a plan view showing a plurality of extension lines ABR' according to the fourth embodiment.

In this case, unlike the plurality of extension lines ABR' described with reference to FIG. 17, a second-third extension line ABR23' may further include a dummy part DP23', a second-fifth extension line ABR25' may further include a dummy part DP25', and a second-seventh extension line ABR27' may further include a dummy part DP27' . In addition, a second-ninth extension line, not shown in FIG. 17, may further include a dummy part DP29'. The second-ninth extension line may be electrically connected to a second-ninth pixel circuit portion disposed in a ninth pixel column and the second pixel row R2, not shown. In addition, the second-ninth extension line may have substantially the same planar shape as the second-fifth extension line ABR25'.

In this case, the dummy part DP23' may be formed integrally with the second-third extension line ABR23' described with reference to FIG. 17, the dummy part DP25' may be formed integrally with the second-fifth extension line ABR25' described with reference to FIG. 17, and the dummy part DP27' may be formed integrally with the second-seventh extension line ABR27' described with reference to FIG. 17.

The dummy part DP23' of the second-third extension line ABR23' may overlap a second data line pair DL2' in the plan view, the dummy part DP25 of the second-fifth extension line ABR25' may overlap the second data line pair DL2' in the plan view, the dummy part DP27' of the second-seventh extension line ABR27' may overlap a fourth data line pair DL4' in the plan view, and the dummy part DP29' of the second-ninth extension line may overlap the fourth data line pair DL4' in the plan view.

Accordingly, each of a first data line pair DL1', the second data line pair DL2', a third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix configuration by the plurality of extension lines ABR' may electrically connected to the first color light emitting portion EB, the second color light emitting portion EG, and the third color light emitting portion ER disposed in a Pentile^{®} configuration.

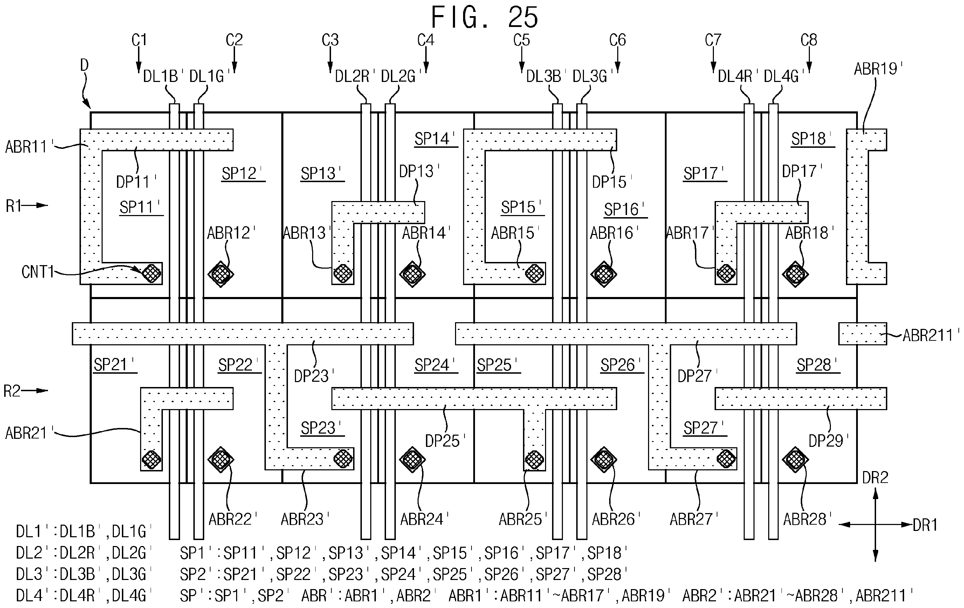

Referring to FIG. 25, FIG. 25 is a plan view showing a plurality of extension lines ABR' according to the fifth embodiment.

In this case, compared to the plurality of extension lines ABR' according to the fourth embodiment described with reference to FIG. 24, in the plurality of extension lines ABR' according to the fifth embodiment, a first-first extension line ABR11' may further include a dummy part DP11', a first-third extension line ABR13' may further include a dummy part DP13', a first-fifth extension line ABR15' may further include a dummy part DP15 , a first-seventh extension line ABR17' may further include a dummy part DP17', and the planar shape of the first-ninth extension line ABR19' may be substantially the same as the planar shape of the first-fifth extension line ABR15' .

In this case, the dummy part DP11' may be formed integrally with the first-first extension line ABR11' described with reference to FIG. 17, the dummy part DP13' may be formed integrally with the first-third extension line ABR13' described with reference to FIG. 17, the dummy part DP15' may be formed integrally with the first-fifth extension line ABR15' described with reference to FIG. 17, and the dummy part DP17' may be formed integrally with the first-seventh extension line ABR17' described with reference to FIG. 17.

The dummy part DP11' may overlap a first data line pair DL1' in the plan view, the dummy part DP13' may overlap a second data line pair DL2' in the plan view, the dummy part DP15' may overlap a third data line pair DL3' in the plan view, and the dummy part DP17' may overlap a fourth data line pair DL4' in the plan view.

Accordingly, each of the first data line pair DL1', the second data line pair DL2', the third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

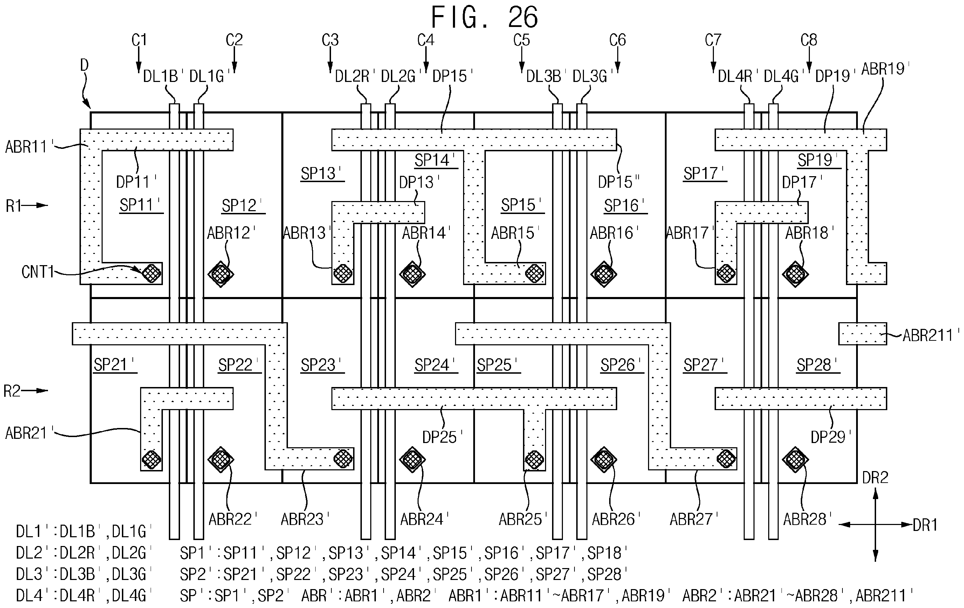

Referring to FIG. 26, FIG. 26 is a plan view showing a plurality of extension lines ABR' according to the sixth embodiment.

In this case, compared to the plurality of extension lines ABR' according to the third embodiment described with reference to FIG. 23, in the plurality of extension lines ABR' according to the fourth embodiment, a first-first extension line ABR11' may further include a dummy part DP11', a first-third extension line ABR13' may further include a dummy part DP13', a first-fifth extension line ABR15' may further include a dummy part DP15", a first-seventh extension line ABR17' may further include a dummy part DP17', and the planar shape of the first-ninth extension line ABR19' may be substantially the same as the planar shape of the first-fifth extension line ABR15' .

In this case, the dummy part DP11' may be formed integrally with the first-first extension line ABR11' described with reference to FIG. 17, the dummy part DP13' may be formed integrally with the first-third extension line ABR13' described with reference to FIG. 17, the dummy part DP 15" may be formed integrally with the first-fifth extension line ABR15' described with reference to FIG. 17, and the dummy part DP17' may be formed integrally with the first-seventh extension line ABR17' described with reference to FIG. 17.

The dummy part DP11' may overlap a first data line pair DL1' in the plan view, the dummy part DP13' may overlap a second data line pair DL2' in the plan view, the dummy part DP15" may overlap a third data line pair DL3' in the plan view, and the dummy part DP17' may overlap a fourth data line pair DL4' in the plan view.

Accordingly, each of the first data line pair DL1', the second data line pair DL2', the third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

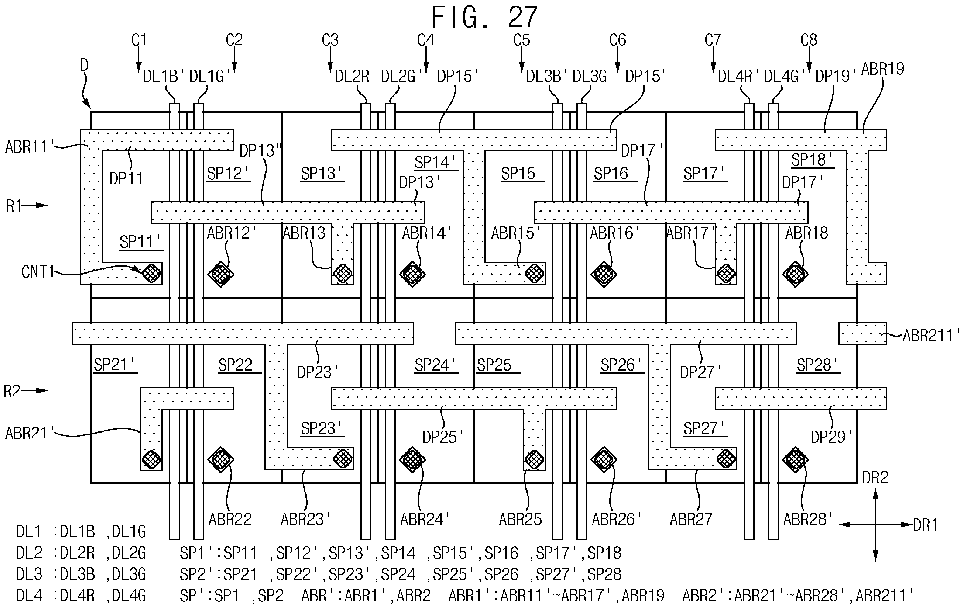

Referring to FIG. 27, FIG. 27 is a plan view showing a plurality of extension lines ABR' according to the seventh embodiment.

In this case, compared to the plurality of extension lines ABR' according to the sixth embodiment described with reference to FIG. 26, in the plurality of extension lines ABR' according to the seventh embodiment, a first-third extension line ABR13' may further include a dummy part DP13", a first-seventh extension line ABR17' may further include a dummy part DP 17", a second-third extension line ABR23' may further include a dummy part DP23', and a second-seventh extension line ABR27' may further include a dummy part DP27".

In this case, the dummy part DP13" may be formed integrally with the first-third extension line ABR13' described with reference to FIG. 17, the dummy part DP17" may be formed integrally with the first-seventh extension line ABR17' described with reference to FIG. 17, the dummy part DP23' may be formed integrally with the second-third extension line ABR23' described with reference to FIG. 17, and the dummy part DP27' may be formed integrally with the second-seventh extension line ABR27' described with reference to FIG. 17.

The dummy part DP13" may overlap a first data line pair DL1' in the plan view, the dummy part DP17" may overlap a second data line pair DL2' in the plan view, the dummy part DP23' may overlap a third data line pair DL3' in the plan view, and the dummy part DP27' may overlap a fourth data line pair DL4' in the plan view.

Accordingly, each of the first data line pair DL1', the second data line pair DL2', the third data line pair DL3', and the fourth data line pair DL4' may overlap the same number of extension lines ABR' in the plan view.

That is, the first data line pair DL1', the second data line pair DL2', the third data line pair DL3', and the fourth data line pair DL4' may be affected by coupling at substantially the same level, so the display quality can be improved.

At the same time, as described with reference to FIGS. 16 and 18, the plurality of pixel circuit portions SP' disposed in a matrix form by the plurality of extension lines ABR' may electrically connected to the first color light emitting portion EB, the second color light emitting portion EG, and the third color light emitting portion ER disposed in a Pentile^{®} configuration.

Referring again to FIGS. 21, 22, 23, 24, 25, 26, and 27, in each of the first, second, third, fourth, fifth, sixth, and seventh embodiments, the first, second, third, and fourth data line pairs DL1', DL2', DL3', and DL4' may overlap the same number of extension lines ABR' in the plan view.

For example, as shown in FIG. 21, in the extension lines ABR' according to the first embodiment, each of the first data line pair DL1' and the third data line pair DL3' may overlap two extension lines in the second pixel row R2 in the plan view, and each of the second data line pair DL2' and the fourth data line pair DL4' may overlap two extension lines in the first pixel row R1 in the plan view.

In addition, as shown in FIGS. 22 and 23, in the extension lines ABR' according to the second and third embodiments, the first data line pair DL1' and the third data line pair DL3' may overlap two extension lines in the second pixel R2 in the plan view, and each of the second data line pair DL2' and the fourth data line pair DL4' may overlap one extension line in the first pixel row R1 in the plan view, and overlap one extension line in the second pixel row R2 in the plan view.

In addition, as shown in FIG. 24, in the extension lines ABR' according to the fourth embodiment, each of the first data line pair DL1' and the third data line pair DL3' may overlap two extension lines in the second pixel row R2 in the plan view, and each of the second data line pair DL2' and the fourth data line pair DL4' may overlap two extension lines in the second pixel row R2 in the plan view.

In addition, as shown in FIG. 25, in the extension lines ABR' according to the fifth embodiment, the first data line pair DL1' and the third data line pair DL3' may overlap one extension line in the first pixel row R1 in the plan view and overlap two extension lines in the second pixel row R2 in the plan view. Each of the second data line pair DL2' and the fourth data line pair DL4' may overlap one extension line in the first pixel row R1 in the plan view, and overlap two extension lines in the second pixel row R2 in the plan view.

In addition, as shown in FIG. 26, in the extension lines ABR' according to the sixth embodiment, the first data line pair DL1' and the third data line pair DL3' may overlap one extension line in the first pixel row R1 in the plan view and overlap two extension lines in the second pixel row R2 in the plan view. Each of the second data line pair DL2' and the fourth data line pair DL4' may overlap two extension lines in the first pixel row R1 in the plan view, and overlap one extension line in the second pixel row R2 in the plan view.

In addition, as shown in FIG. 27, in the extension lines ABR' according to the seventh embodiment, the first data line pair DL1' and the third data line pair DL3' may overlap two extension lines in the first pixel row R1 in the plan view and overlap two extension lines in the second pixel row R2 in the plan view. Each of the second data line pair DL2' and the fourth data line pair DL4' may overlap two extension lines in the first pixel row R1 in the plan view, and overlap two extension lines in the second pixel row R2 in the plan view.

The present invention can be applied to display devices included in computers, smart pads, smartphones, automobiles, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A display device (DDa, DDb, DDc, DDd) comprising:
a first-first pixel circuit portion (SP11) positioned in a first pixel row (R1) and a first pixel column (C1);
a first-second pixel circuit portion (SP12) positioned in the first pixel row (R1) and a second pixel column (C2);
a second-first pixel circuit portion (SP21) positioned in a second pixel row (R2) and the first pixel column (C1);
a second-second pixel circuit portion (SP22) positioned in the second pixel row (R2) and the second pixel column (C2);
a first sub-data line (DL1B) overlapping the first-first pixel circuit portion (SP11) and the second-first pixel circuit portion (SP21) in a plan view and extending in a column direction (DR2); and
a second sub-data line (DL1G) overlapping the first-second pixel circuit portion (SP12) and the second-second pixel circuit portion (SP22) in the plan view ad extending in the column direction (DR2),
wherein each of the first-first pixel circuit portion (SP11) and the second-second pixel circuit portion (SP22) is electrically connected to the first sub-data line (DL1B), and
each of the first-second pixel circuit portion (SP12) and the second-first pixel circuit portion (SP21) is electrically connected to the second sub-data line (DL1G).

2. The display device (DDa, DDb, DDc, DDd) of claim 1, wherein the first-first pixel circuit portion (SP11) and the first-second pixel circuit portion (SP12) are symmetrical to each other, and
the second-first pixel circuit portion (SP21) and the second-second pixel circuit portion (SP22) are asymmetrical to each other.

3. The display device (DDa, DDb, DDc, DDd) of claim 1 or 2, wherein the first-first pixel circuit portion (SP11) includes a first-first semiconductor pattern (ATV11),
the first-second pixel circuit portion (SP12) includes a first-second semiconductor pattern (ATV12),
the second-first pixel circuit portion (SP21) includes a second-first semiconductor pattern (ATV21),
the second-second pixel circuit portion (SP22) includes a second-second semiconductor pattern (ATV22),
the first-first semiconductor pattern (ATV11) and the first-second semiconductor pattern (ATV12) are symmetrical to each other, and
the second-first semiconductor pattern (ATV21) and the second-second semiconductor pattern (ATV22) are asymmetrical to each other.

4. The display device (DDa, DDb, DDc, DDd) of claim 3, wherein each of the first-first semiconductor pattern (ATV11) and the second-second semiconductor pattern (ATV22) is electrically connected to the first sub-data line (DL1B), and
each of the first-second semiconductor pattern (ATV12) and the second-first semiconductor pattern (ATV21) is electrically connected to the second sub-data line (DL1G).

5. The display device (DDa, DDb, DDc, DDd) of at least one of claims 1 to 4, further comprising:
a first-third pixel circuit portion (SP13) positioned in the first pixel row (R1) and a third pixel column (C3);
a first-fourth pixel circuit portion (SP14) positioned in the first pixel row (R1) and a fourth pixel column (C4);
a second-third pixel circuit portion (SP23) positioned in the second pixel row (R2) and the third pixel column (C3);
a second-fourth pixel circuit portion (SP24) positioned in the second pixel row (R2) and the fourth pixel column (C4);
a third sub-data line (DL2R) overlapping the first-third pixel circuit portion (SP13) and the second-third pixel circuit portion (SP23) in the plan view and extending in the column direction (DR2); and
a fourth sub-data line (DL2G) overlapping the first-fourth pixel circuit portion (SP14) and the second-fourth pixel circuit portion (SP24) in the plan view ad extending in the column direction (DR2),
wherein each of the first-third pixel circuit portion (SP13) and the second-fourth pixel circuit portion (SP24) is electrically connected to the third sub-data line (DL2R), and
each of the first-fourth pixel circuit portion (SP14) and the second-fourth pixel circuit portion (SP24) is electrically connected to the fourth sub-data line (DL2G).

6. The display device (DDa, DDb, DDc, DDd) of claim 5, further comprising:
a first-first light emitting portion (EB11) electrically connected to the first-first pixel circuit portion (SP11) and that emits light of a first color;
a first-second light emitting portion (EG12) electrically connected to the first-second pixel circuit portion (SP12) and that emits light of a second color;
a first-third light emitting portion (ER13) electrically connected to the first-third pixel circuit portion (SP13) and that emits light of a third color; and
a first-fourth light emitting portion (EG14) electrically connected to the first-fourth pixel circuit portion (SP14) and that emits light of the second color.

7. The display device (DDa, DDb, DDc, DDd) of claim 6, further comprising:
a second-first light emitting portion (EG21) electrically connected to the second-first pixel circuit portion (SP21) and that emits light of the second color;
a second-second light emitting portion (EB22) electrically connected to the second-second pixel circuit portion (SP22) and that emits light of the first color;
a second-third light emitting portion (EG23) electrically connected to the second-third pixel circuit portion (SP23) and that emits light of the second color; and
a second-fourth light emitting portion (ER24) electrically connected to the second-fourth pixel circuit portion (SP24) and that emits light of the third color.

8. The display device (DDa, DDb, DDc, DDd) of claim 7, wherein the first-first light emitting portion (EB11) and the first-third light emitting portion (ER13) are arranged in a row direction (DR1) crossing the column direction (DR2),
the first-second light emitting portion (EG12) and the first-fourth light emitting portion (EG14) are arranged in the row direction (DR1) and are spaced apart from the first-first light emitting portion (EB11) and the first-third light emitting portion (ER13) in the column direction (DR2),
the second-second light emitting portion (EB22) and the second-fourth light emitting portion (ER24) are arranged in the row direction (DR1) and are spaced apart from the first-second light emitting portion (EG12) and the first-fourth light emitting portion (EG14) in the column direction (DR2), and
the second-first light emitting portion (EG21) and the second-third light emitting portion (EG23) are arranged in the row direction (DR1) and are spaced apart from the second-second light emitting portion (EB22) and the second-fourth light emitting portion (ER24) in the column direction (DR2).

9. The display device (DDa, DDc, DDd) of at least one of claims 1 to 8, further comprising:
a first-zeroth dummy pixel circuit portion (DSP10) disposed in the first pixel column (C1) and a dummy pixel column (C0) adjacent to the first pixel row (R1) and spaced apart from the second pixel column (C2);
a second-zeroth dummy pixel circuit portion (DSP20) disposed in the second pixel row (R2) and the dummy pixel column (C0);
a dummy data line (DL0) overlapping the first-zeroth dummy pixel circuit portion (DSP10) and the second-zeroth dummy pixel circuit portion (DSP20) in the plan view, electrically connected to the second-zeroth dummy pixel circuit portion (DSP20), and extending in the column direction (DR2); and
a second-zeroth light emitting portion (ER20) electrically connected to the second-zeroth dummy pixel circuit portion (DSP20).

10. The display device (DDa, DDc, DDd) of claim 7 and 9, wherein the second-zeroth light emitting portion (ER20), the second-second light emitting portion (EB22), and the second-fourth light emitting portion (ER24) are arranged in the row direction (DR1).

11. The display device (DDb, DDc, DDd) of at least one of claims 1 to 8, further comprising:
a second-zeroth light emitting portion (ER20) electrically connected to the first-third pixel circuit portion (SP13) through the first-third light emitting portion (ER13); and
a connection electrode (CNE) electrically connecting an anode electrode of the first-third light emitting portion (ER13) and an anode electrode of the second-zeroth light emitting portion (ER20).

12. The display device (DDb, DDc, DDd) of claim 7 and 11, wherein the second-zeroth light emitting portion (ER20), the second-second light emitting portion (EB22), and the second-fourth light emitting portion (ER24) are arranged in the row direction (DR1).

13. A display device (DDa, DDb, DDc, DDd) comprising:
a plurality of first pixel circuit portions (SP1') disposed in a row direction (DR1) along a first pixel row (R1);
a plurality of second pixel circuit portions (SP2') disposed in the row direction (DR1) along a second pixel row (R2);
a plurality of sub-data lines (DL1B', DL1G', DL2R', DL2G', DL3R', DL3G', DL4R', DL4G') electrically connected to the plurality of first pixel circuit portions (SP1') and the plurality of second pixel circuit portions (SP2'), and extending in a column direction (DR2) crossing the row direction (DR1);
a plurality of extension lines (ABR') including a plurality of first extension lines (ABR1') electrically connected one-to-one with the plurality of first pixel circuit portions (SP1') and a plurality of second extension lines (ABR2') electrically connected one-to-one with the plurality of second pixel circuit portions (SP2');
a plurality of first light emitting portions (EB15', EB19', EG12', EG14', EG16', EG18', ER13', ER17') electrically connected one-to-one with the plurality of first extension lines (ABR1'); and
a plurality of second light emitting portions (EB21', EB25 , EG22', EG25', EG26', EG28', ER23', ER27 , ER211') 'electrically connected one-to-one with the plurality of second extension lines (ABR2'),
wherein the number of the plurality of extension lines (ABR') overlapping in a plan view a sub-data line disposed in a Nth pixel column among the plurality of sub-data lines (DL1B', DL1G', DL2R', DL2G', DL3R', DL3G', DL4R', DL4G') is a same as the number of the plurality of extension lines (ABR') overlapping in the plan view to on a sub-data line disposed in a (N+2)th pixel column among the plurality of sub-data lines (DL1B', DL1G', DL2R', DL2G', DL3R', DL3G', DL4R', DL4G'), where N=4M+1 and M is an integer equal to or greater than 0.

14. The display device (DDa, DDb, DDc, DDd) of claim 13, wherein the plurality of extension lines (ABR') overlapping in the plan view a sub-data line disposed in the Nth pixel column among the plurality of sub-data lines (DL1B', DL1G', DL2R', DL2G', DL3R', DL3G', DL4R', DL4G') also overlaps a sub-data line disposed in a (N+1)th pixel column among the plurality of sub-data lines (DL1B', DL1G', DL2R', DL2G', DL3R', DL3G', DL4R', DL4G') in the plan view.

15. The display device (DDa, DDb, DDc, DDd) of claim 13 or 14, wherein the plurality of extension lines (ABR') overlapping in the plan view the sub-data line disposed in the (N+2)th pixel column among the plurality of sub-data lines (DL1B', DL1G', DL2R', DL2G', DL3R', DL3G', DL4R', DL4G') also overlaps a sub-data line disposed in a (N+3)th pixel column among the plurality of sub-data lines (DL1B', DL1G', DL2R', DL2G', DL3R', DL3G', DL4R', DL4G') in the plan view.

16. The display device (DDa, DDb, DDc, DDd) of claim 13, wherein the sub-data line disposed in the Nth pixel column among the plurality of sub-data lines (DL1B', DL1G', DL2R', DL2G', DL3R', DL3G', DL4R', DL4G') overlaps two second extension lines (ABR2') among the plurality of second extension lines (ABR2') in the plan view.

17. The display device (DDa, DDb, DDc, DDd) of claim 16, wherein the sub-data line disposed in the (N+2)th pixel column among the plurality of sub-data lines (DL1B', DL1G', DL2R', DL2G', DL3R', DL3G', DL4R', DL4G') overlaps two first extension lines (ABR1') among the plurality of first extension lines (ABR1') in the plan view.

18. The display device (DDa, DDb, DDc, DDd) of claim 16, wherein the sub-data line disposed in the (N+2)th pixel column among the plurality of sub-data lines (DL1B', DL1G', DL2R', DL2G', DL3R', DL3G', DL4R', DL4G') overlaps two second extension lines (ABR2') among the plurality of second extension lines (ABR2') in the plan view.

19. The display device (DDa, DDb, DDc, DDd) of at least one of claims 13 to 16, wherein the sub-data line disposed in the (N+2)th pixel column among the plurality of sub-data lines (DL1B', DL1G', DL2R', DL2G', DL3R', DL3G', DL4R', DL4G') overlaps one second extension line (ABR2') among the plurality of second extension lines (ABR2') and one first extension line (ABR1') among the plurality of first extension lines (ABR1').

20. The display device (DDa, DDb, DDc, DDd) of at least one of claims 13 to 15, wherein the sub-data line disposed in the Nth pixel column among the plurality of sub-data lines (DL1B', DL1G', DL2R', DL2G', DL3R', DL3G', DL4R', DL4G') overlaps two second extension lines (ABR2') among the plurality of second extension lines (ABR2') and one first extension line (ABR1') among the plurality of first extension lines (ABR1').

21. The display device (DDa, DDb, DDc, DDd) of claim 20, wherein the sub-data line disposed in the (N+2)th pixel column among the plurality of sub-data lines (DL1B', DL1G', DL2R', DL2G', DL3R', DL3G', DL4R', DL4G') overlaps one first extension line (ABR1') among the plurality of first extension lines (ABR1') and two second extension lines (ABR2') among the plurality of second extension lines (ABR2').

22. The display device (DDa, DDb, DDc, DDd) of claim 20, wherein the sub-data line disposed in the (N+2)th pixel column among the plurality of sub-data lines (DL1B', DL1G', DL2R', DL2G', DL3R', DL3G', DL4R', DL4G') overlaps two first extension lines (ABR1') among the plurality of first extension lines (ABR1') and one second extension line (ABR2') among the plurality of second extension lines (ABR2').

23. The display device (DDa, DDb, DDc, DDd) of at least one of claims 13 to 15, wherein the sub-data line disposed in the Nth pixel column among the plurality of sub-data lines (DL1B', DL1G', DL2R', DL2G', DL3R', DL3G', DL4R', DL4G') overlaps two first extension lines (ABR1') among the plurality of first extension lines (ABR1') and two second extension lines (ABR2') among the plurality of second extension lines (ABR2').

24. The display device (DDa, DDb, DDc, DDd) of claim 23, wherein the sub-data line disposed in the (N+2)th pixel column among the plurality of sub-data lines (DL1B', DL1G', DL2R', DL2G', DL3R', DL3G', DL4R', DL4G') overlaps two first extension lines (ABR1') among the plurality of first extension lines (ABR1') and two second extension lines (ABR2') among the plurality of second extension lines (ABR2').
